(19) Europäisches Patentamt
European Patent Office
Office européen des brevets

(11) EP 2 145 926 B1

(12) # EUROPÄISCHE PATENTSCHRIFT

(45) Veröffentlichungstag und Bekanntmachung des Hinweises auf die Patenterteilung:
**30.05.2012 Patentblatt 2012/22**

(51) Int Cl.:
***C09B 67/00*** *(2006.01)* ***G02B 5/22*** *(2006.01)*
***G03F 7/00*** *(2006.01)*

(21) Anmeldenummer: **09007597.9**

(22) Anmeldetag: **09.06.2009**

(54) **PR 254-Pigmentzubereitung zur Verwendung in Colorfiltern**

PR 254 pigment preparation for use in colour filters

Préparation de pigment PR 254 destinée à l'utilisation dans des filtres colorés

(84) Benannte Vertragsstaaten:
**CH DE FR GB LI**

(30) Priorität: **08.07.2008 DE 102008032090**

(43) Veröffentlichungstag der Anmeldung:
**20.01.2010 Patentblatt 2010/03**

(73) Patentinhaber: **Clariant Finance (BVI) Limited**
**Road Town, Tortola (VG)**

(72) Erfinder:
- **Reipen, Tanja, Dr.**
  **55124 Mainz (DE)**
- **Reichwagen, Jens, Dr.**
  **65203 Wiesbaden (DE)**
- **Schneider, Lars, Dr.**
  **65835 Liederbach (DE)**
- **Plüg, Carsten, Dr.**
  **64367 Mühltal/Niederbeerbach (DE)**
- **Blum, David, Dr.**
  **08771-910 Mogi das Cruces,**
  **Sao Paulo (BR)**

(74) Vertreter: **Hütter, Klaus et al**
**Clariant Produkte (Deutschland) GmbH**
**Group Intellectual Property**
**Am Unisys-Park 1**
**65843 Sulzbach (DE)**

(56) Entgegenhaltungen:
**EP-A1- 1 884 543** **EP-A2- 1 104 789**
**EP-A2- 1 715 007** **DE-A1- 10 235 573**
**US-A1- 2006 185 558** **US-A1- 2008 107 977**

- **DATABASE WPI Week 200603 Thomson Scientific, London, GB; AN 2006-025329 XP002597303 -& JP 2005 345884 A (TOYO INK MFG CO LTD) 15. Dezember 2005 (2005-12-15)**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 145 926 B1

## Beschreibung

Die vorliegende Erfindung betrifft eine neue Pigmentzubereitung aus feinteiligem P.R. 254 und bestimmten Pigmentdispergatoren, sowie die Verwendung dieses neuen Produkts als Pigment.

Für viele Anwendungen von organischen Pigmenten ist eine sehr gute Dispergierbarkeit, eine niedrige Viskosität und eine hohe Lagerstabilität erforderlich, wie zum Beispiel bei der Einfärbung von Metalliclacken oder der Verwendung in Farbfiltern.

Bei den Farbfiltern werden beim Vorgang des Spincoatens dünnflüssige, stabile Pigmentsuspensionen gebraucht, um die Herstellung des Colorfilterlacks mit gleichmäßiger Schichtdicke zu ermöglichen.

Zur Herstellung von Farbfiltern werden besonders feinteilige Pigmente eingesetzt, um die Partikel-Streuung, die zu einer Herabsetzung des Kontrastverhältnisses führt, weitgehend auszuschließen.

Für die Messung des Kontrastverhältnisses (KV) wird die Lichtintensität nach Durchstrahlen einer pigmentierten Lackschicht auf einem transparenten Substrat bestimmt, bei der sich das Substrat zwischen zwei Polarisatoren befindet. Das Kontrastverhältnis gibt das Verhältnis der Lichtintensitäten bei parallelen und senkrecht stehenden Polarisatoren an.

$$KV = \frac{Licht\,\mathrm{int}\,ensit\ddot{a}t\,(parallel)}{Licht\,\mathrm{int}\,ensit\ddot{a}t\,(senkrecht)}$$

Die kommerziell erhältlichen Handelsprodukte genügen jedoch nicht immer allen Anforderungen der Technik. Insbesondere bestand ein Verbesserungsbedarf hinsichtlich der Dispergierbarkeit und der Viskosität und Lagerstabilität dieser feinteiligen Pigmente ohne negativen Einfluss auf Chroma und Farbton.

In der JP 2005-345884 A wird z. B. ein P.R. 254 mit Anthrachinon-Pigmenten und einem Pigment-Dispergator mit basischen Gruppen kombiniert und in einem Colorfilter eingesetzt.

Die DE 10 235 573 A1 beschreibt Pigmentzubereitungen aus DPP-Pigmenten und sulfonierten DPP-Derivaten zum verzugsfreien Pigmentieren von teilkristallinen Kunststoffen.

Die EP 1 884 543 A1 beschreibt ebenfalls die Kombination von P.R. 254 mit einem DPP-Derivat als Dispergator.

US-A-5,869,625 beschreibt Mischungen von opaken DPP Pigmenten und salzbildenden Azopigmenten für Automobillack-Anwendungen.

JP 2001 214107 beschreibt eine Zusammensetzung von Pigmenten, salzbildenden Azopigmenten und einem kationischen Dispergierhilfsmittel für Schreibtinten.

EP-A-1 715 007 beschreibt den Einsatz von Disazokondensationsdispergatoren auf Basis von C.I. Pigment Rot 242 für die Anwendung in Farbfiltern.

US 2006 185558 A beschreibt den Einsatz einer Mischung aus sulfonsäuregruppenhaltigen DPP-Pigmenten, sulfonsäuregruppenfreien DPP-Pigmenten und Disazokondensationsdispergatoren auf Basis von C.I. Pigment Rot 242 für die Anwendung in Farbfiltern.

US 2008 0107977 beschreibt transparente Pigmentzusammensetzungen für Colorfilter mit salzbildenden Azosynergisten.

Da die Ansprüche an Pigmente z. B. für Colorfilteranwendungen immer weiter steigen, sind die Eigenschaften der bekannten Pigmentzusammensetzungen für "top-grade" Pigmente nicht ausreichend. Insbesondere besteht Verbesserungsbedarf hinsichtlich Dispergierbarkeit, Viskosität und Lagerstabilität.

Es bestand die Aufgabe, eine Diketopyrrolopyrrol-Pigmentzubereitung insbesondere für Farbfilteranwendungen zur Verfügung zu stellen, die eine gute Dispergierbarkeit, eine stabile niedrige Viskosität in organischen Lacksystemen und einen hohen Kontrastwert aufweisen.

Es wurde gefunden, dass eine Mischung aus einem P.R. 254 und mindestens einem Dispergator aus der Gruppe der unverlackten, sulfogruppenhaltigen Monoazofarbstoffe und einem weiteren basischen Dispergator diese Aufgabe überraschenderweise löst.

Gegenstand der Erfindung ist eine Pigmentzubereitung, enthaltend

(a) C.I. Pigment Red 254 einer mittleren Teilchengröße $d_{50}$ von höchstens 100 nm, z. B. 20 bis 100 nm, insbesondere 30 bis 80 nm;

(b) 0,1 bis 30 Gew.-%, vorzugsweise 1 bis 25 Gew.-%, bezogen auf das Gewicht des P.R. 254, eines oder mehrerer Dispergatoren aus der Gruppe der unverlackten, sulfogruppenhaltigen Monoazofarbstoffe der Formel (I), (II), (III) oder (IV)

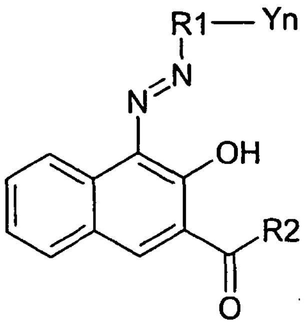 (I)

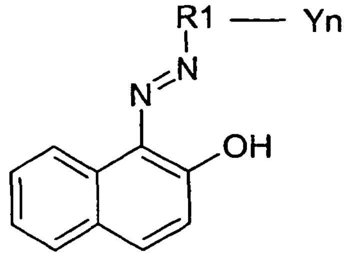 (II)

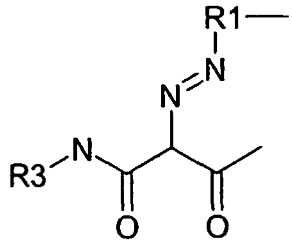 (III)

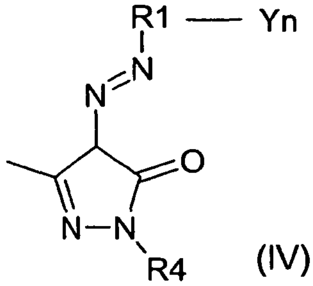 (IV)

worin

| | |
|---|---|
| R1 | ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon; wobei die genannten Aromaten- und Heteroaromaten-Reste durch 1, 2, 3 oder 4 Substituenten aus der Gruppe OH, CN, F, Cl, Br, $NO_2$, $CF_3$, $C_1$-$C_6$-Alkoxy, S-$C_1$-$C_6$-Alkyl, $NHCONH_2$, $NHC(NH)NH_2$, NHCO-$C_1$-$C_6$-Alkyl, $C_1$-$C_6$-Alkyl, COOR5, CONR5R6, $SO_3R5$, $SO_2$-NR5R6 oder $COO^-E^+$ substituiert sein können, wobei R5 und R6 gleich oder verschieden sind und Wasserstoff, Phenyl oder $C_1$-$C_6$-Alkyl und $E^+$ Wasserstoff, Lithium, Natrium, Kalium, Rubidium, Cäsium oder ein unsubstituiertes Ammoniumion bedeuten; |
| Y | $SO_3^-$ $E^+$ oder Z-$SO_3^-$ $E^+$, wobei Z $C_1$ - $C_{10}$-Alkylen oder Phenylen bedeutet; |
| n | die Zahl 1, 2 oder 3; |
| R2 | -$OR^8$ oder -$NHR^8$, wobei $R^8$ die Bedeutung H, $C_1$-$C_6$-Alkyl, Benzyl, ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon, hat; wobei die genannten Aromaten- und Heteroaromaten-Reste jeweils durch 1, 2, 3 oder 4 Substituenten aus der Gruppe OH, $C_1$-$C_6$-Alkoxy, S-$C_1$-$C_6$- Alkyl, Halogen, wie F, Cl, Br, $NHCONH_2$, $NHC(NH)NH_2$, NHCO-$C_1$-$C_6$-Alkyl, $C_1$-$C_6$-Alkyl, Nitro, COOR5, CONR5R6, $SO_3R5$, $SO_2$-NR5R6, $SO_3^-E^+$ oder $COO^-E^+$ substituiert sein können, wobei R5 und R6 gleich oder verschieden sind und Wasserstoff, Phenyl oder $C_1$-$C_6$-Alkyl bedeuten; |
| R3 und R4 | jeweils ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon; wobei die genannten Aromaten- und Heteroaromaten-Reste jeweils durch 1, 2, 3 oder 4 Substituenten aus der Gruppe OH, $C_1$-$C_6$-Alkoxy, S-$C_1$-$C_6$- Alkyl, Halogen, wie F, Cl, Br, $NHCONH_2$, $NHC(NH)NH_2$, NHCO-$C_1$-$C_6$-Alkyl, $C_1$-$C_6$-Alkyl, Nitro, COOR5, CONR5R6, $SO_3R5$, $SO_2$-NR5R6, $SO_3^-E^+$ oder $COO^-E^+$ substituiert sein können, wobei R5 und R6 gleich oder verschieden sind und Wasserstoff, Phenyl oder $C_1$-$C_6$-Alkyl bedeuten; |

(c) 0,1 bis 30 Gew.-%, vorzugsweise 1 bis 25 Gew.-%, bezogen auf das Gewicht des PR 254, eines basischen

Pigmentdispergators der Formel (5)

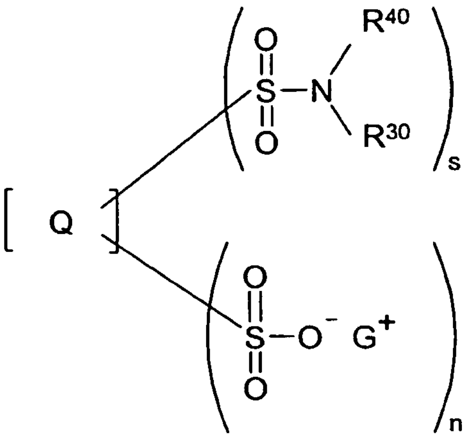

(5)

worin

- Q ein Rest eines organischen Pigments aus der Gruppe der Perinon-, Chinacridon-, Chinacridonchinon-, Anthanthron-, Indanthron-, Dioxazin-, wie beispielsweise Triphendioxazine, Diketopyrrolopyrrol-, Indigo-, Thioindigo-, Thiazinindigo-, Isoindolin-, Isoindolinon-, Pyranthron-, Isoviolanthron-, Flavanthron- oder Anthrapyrimidin-Pigmente ist;
- s eine Zahl von 1 bis 5, vorzugsweise 1 bis 3, darstellt;
- n eine Zahl von 0 bis 4, vorzugsweise 0,1 bis 2, darstellt; wobei die Summe von s und n 1 bis 5 beträgt und s größer als n ist;
- $R^{30}$ einen verzweigten oder unverzweigten, gesättigten oder ungesättigten, aliphatischen Kohlenwasserstoffrest mit 1 bis 20 C-Atomen, oder einen $C_5$-$C_7$-Cycloalkylrest, oder einen araliphatischen oder aromatischen Rest mit 1, 2 oder 3 aromatischen Ringen, wobei die Ringe kondensiert vorliegen oder durch eine Bindung verknüpft sein können, oder einen heterocyclischen Rest mit 1, 2 oder 3 Ringen, enthaltend 1, 2, 3 oder 4 Heteroatome aus der Gruppe O, N und S, oder eine Kombination davon bedeutet; wobei die genannten Kohlenwasserstoff-, Cycloalkyl-, Aromaten-, Araliphaten- und Heteroaromaten-Reste durch 1, 2, 3 oder 4 Substituenten aus der Gruppe OH, CN, F, Cl, Br, $NO_2$, $CF_3$, $C_1$-$C_6$-Alkoxy, S-$C_1$-$C_6$-Alkyl, $NHCONH_2$, $NHC(NH)NH_2$, NHCO-$C_1$-$C_6$-Alkyl, $C_1$-$C_6$-Alkyl, $CONR^5R^6$, $NR^5R^6$, $SO_2$-$NR^5R^6$ substituiert sein können, wobei $R^5$ und $R^6$ gleich oder verschieden sind und Wasserstoff, Phenyl oder $C_1$-$C_6$-Alkyl bedeuten, mit der Maßgabe, dass in den genannten Kohlenwasserstoff-, Cycloalkyl-, Aromaten-, Araliphaten- oder Heteroaromaten-Resten mindestens eine basische Aminogruppe enthalten ist;
- $R^{40}$ Wasserstoff oder $R^{30}$ bedeutet;
- $G^+$ die Bedeutung $H^+$, Alkalimetall oder substituiertes oder unsubstituiertes Ammoniumion hat.

Das Gewichtsverhältnis der Komponenten (b) und (c) zueinander ist vorzugsweise etwa 1: 1, d.h. 1 zu 0,8 bis 1,2.

In den Monoazofarbstoffen der Komponente (b) hat der Rest - R1 - Yn folgende bevorzugte Bedeutungen, wobei die freie Valenz am Phenylring oder Naphthylring die Bindung zur Diazo-Gruppe darstellt:

(i) aus der Gruppe der p-Amino-Benzolsulfonsäuren:

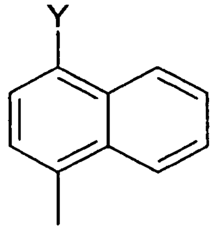
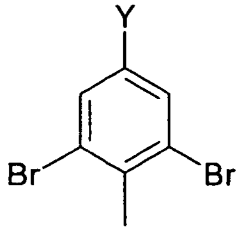
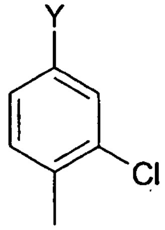
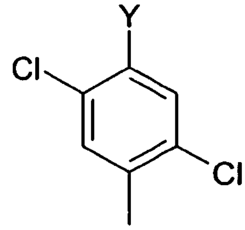

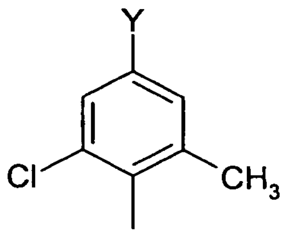
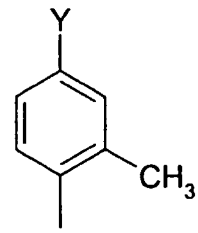
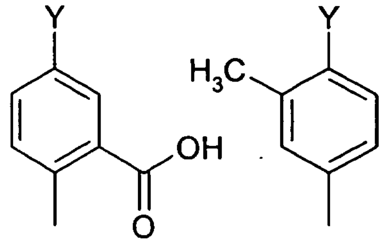

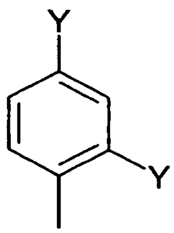
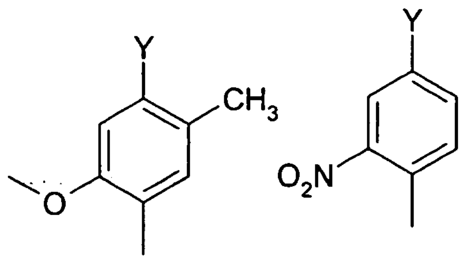
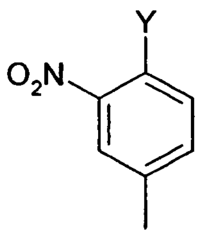

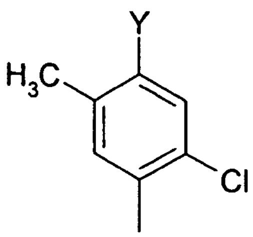
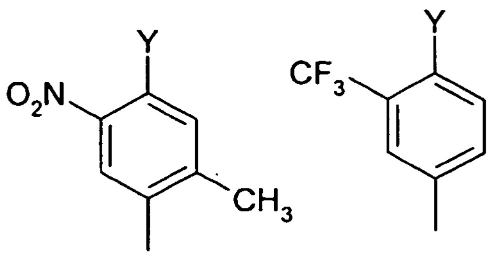
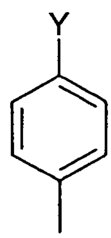

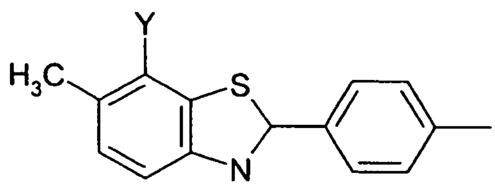

(ii) aus der Gruppe der *m*-Amino-Benzolsulfonsäuren:

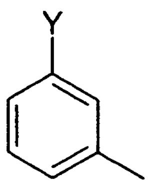
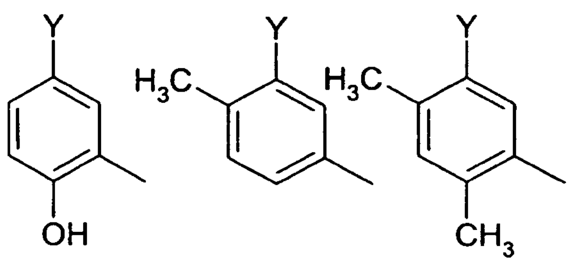
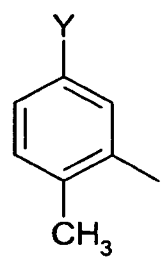

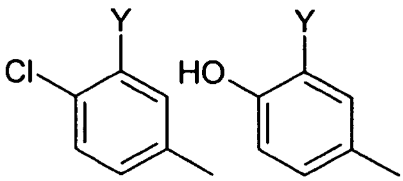
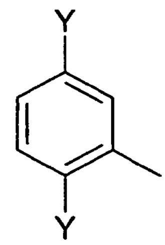
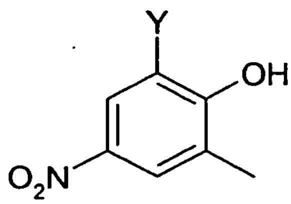

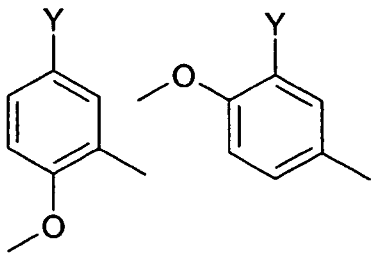
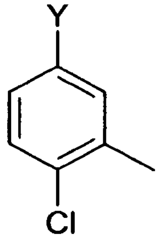
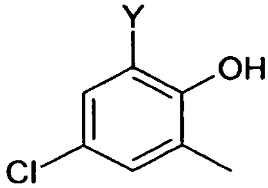

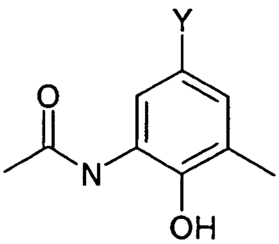
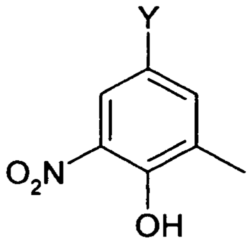
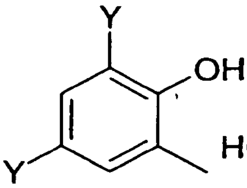
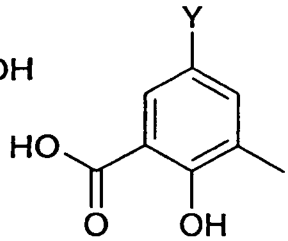

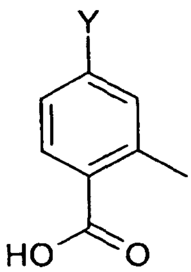
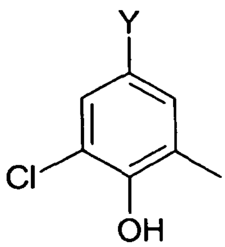
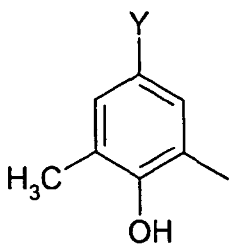
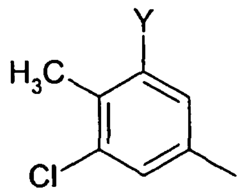

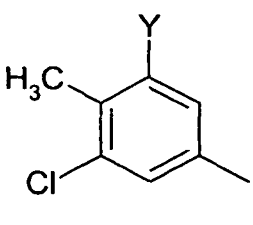
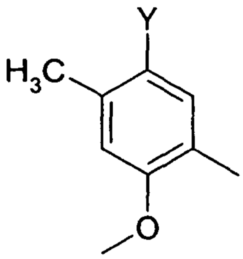
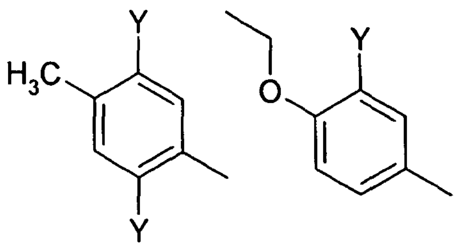

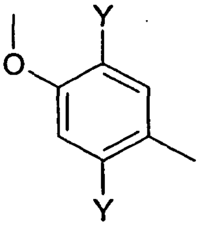
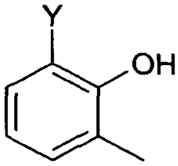
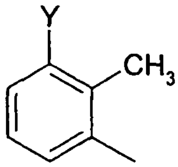
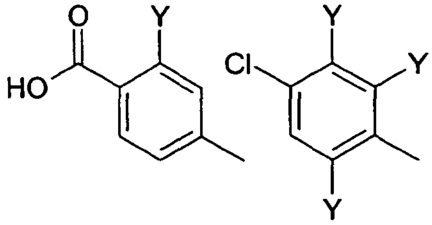

(iii) aus der Gruppe der *o*-Amino-Benzolsulfonsäuren:

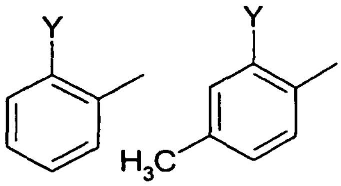
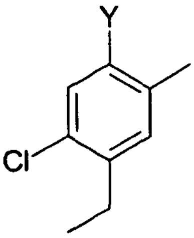
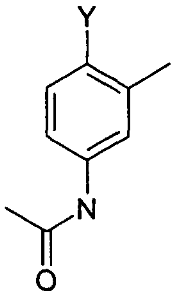

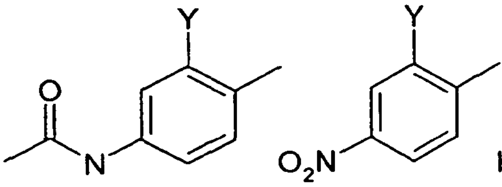
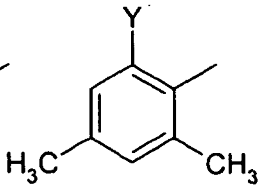
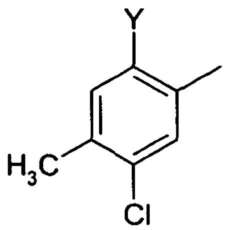

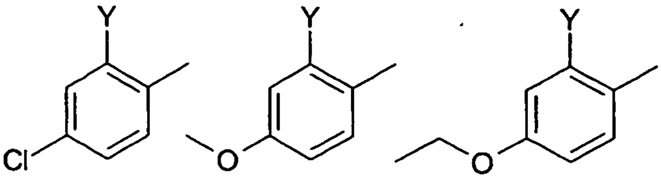
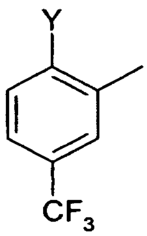

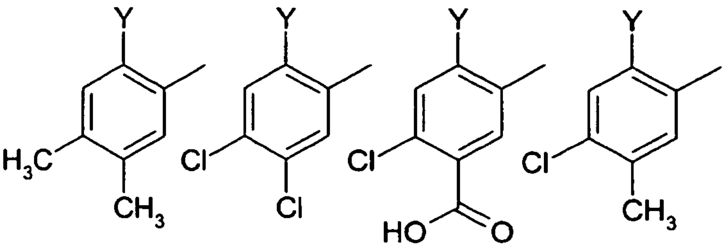

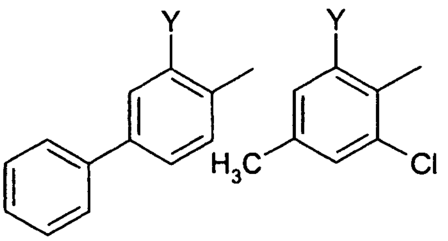
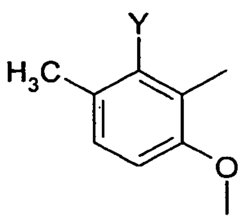
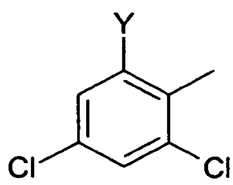

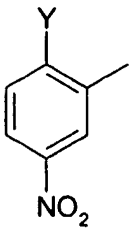
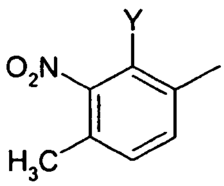
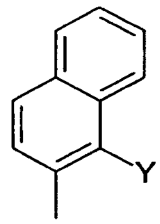

Besonders bevorzugte Reste aus der Gruppe - R1 - Yn sind:

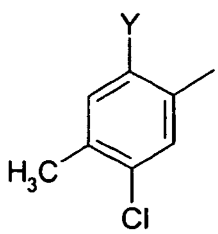
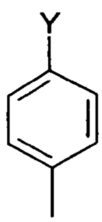
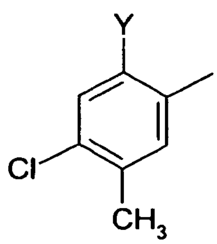

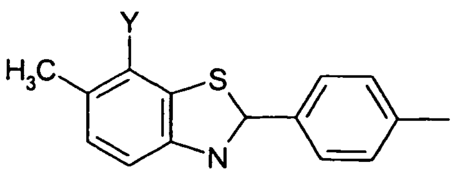
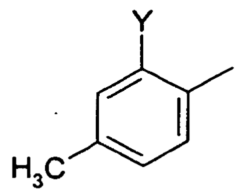

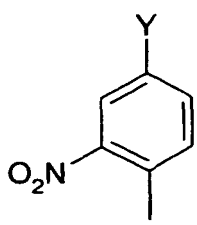
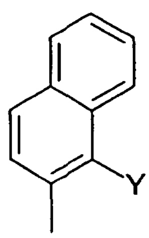

Bevorzugte Verbindungen der Formel (I) im Sinne der Erfindung:

In einer ersten Ausführungsform hat der Rest -R2 die Bedeutung OH oder O-$C_1$-$C_6$-Alkyl. In einer alternativen Ausführungsform bedeutet der Rest -CO-R2 eine Amidgruppe mit R2 gleich $NH_2$,

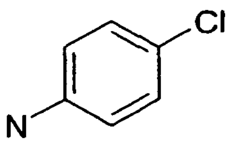
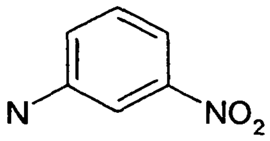
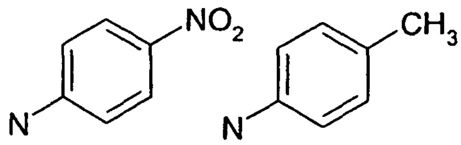

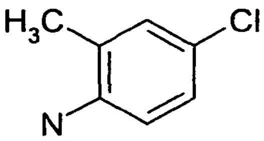
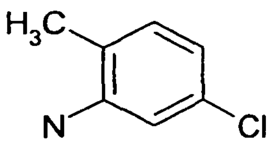
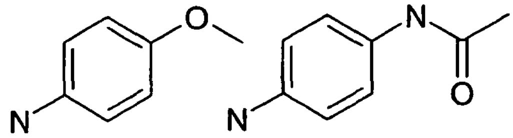

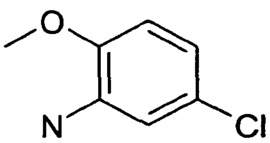
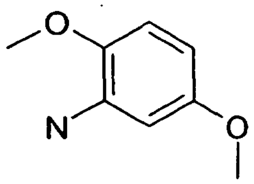
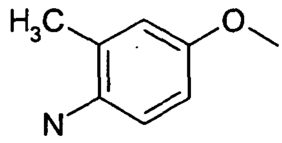

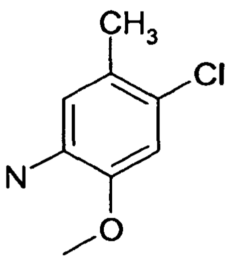
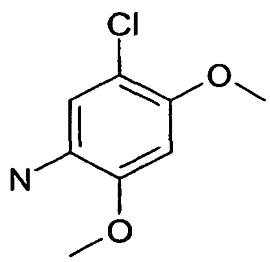
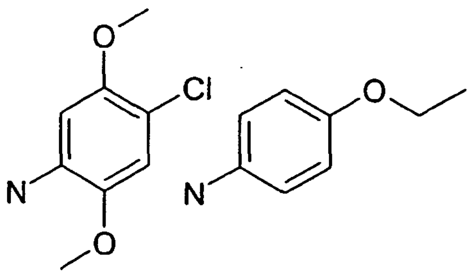

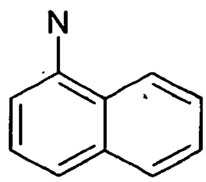
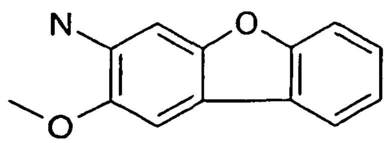
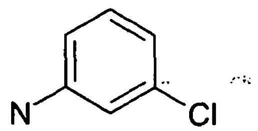

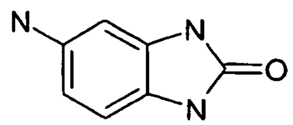

wobei in den vorstehenden Formeln die Bindung zur Carbonylgruppe über die freie Aminogruppe (N -) des Aromatenringes erfolgt.

Besonders bevorzugte Reste aus der Gruppe - R2 sind:

OH einerseits, sowie

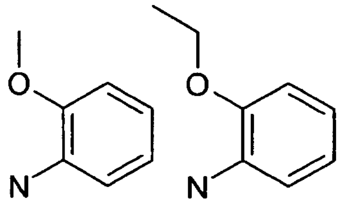
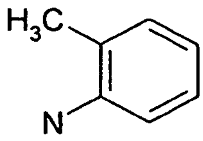

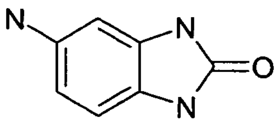
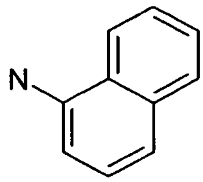

Bevorzugte Verbindungen der Formel (III) im Sinne der Erfindung sind solche mit folgenden Resten -R3, wobei die freie Valenz am Phenylring die Bindung zum Stickstoff darstellt:

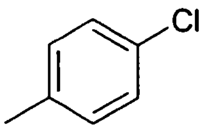
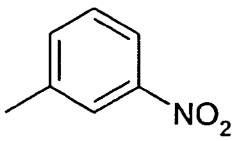
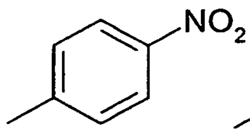
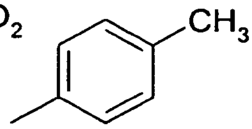

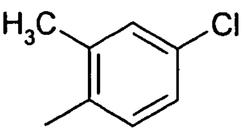
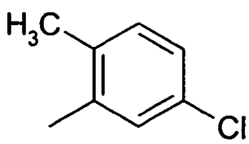
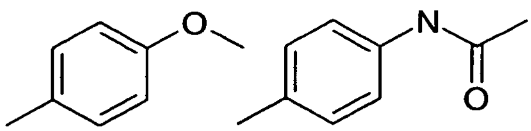

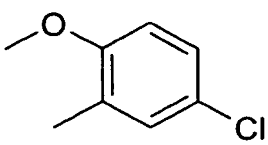
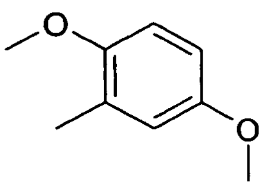
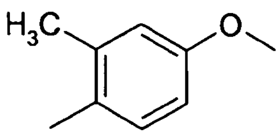

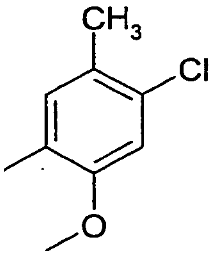 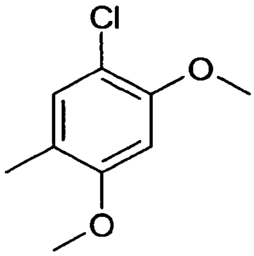 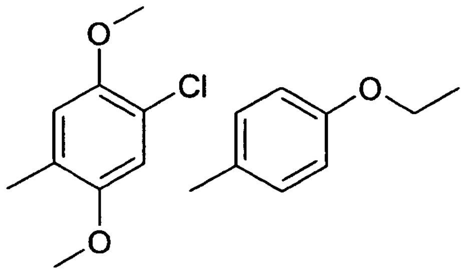

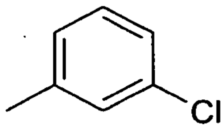 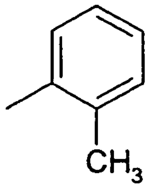

Besonders bevorzugte Reste aus der Gruppe - R3 sind:

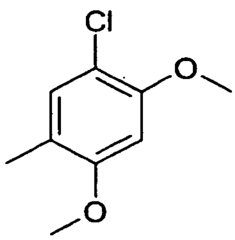 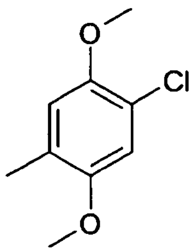

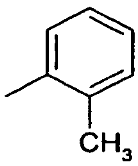 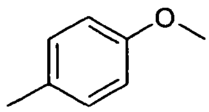

Bevorzugte Verbindungen der Formel (IV) im Sinne der Erfindung sind solche mit folgenden Resten - R4, wobei die freie Valenz am Phenylring die Bindung zum Stickstoff darstellt:

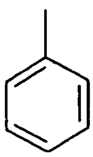 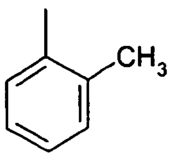 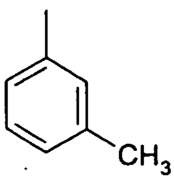 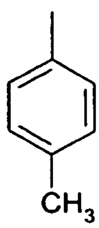

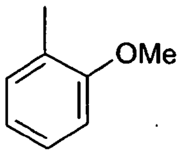

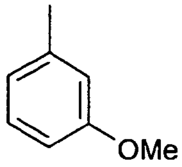

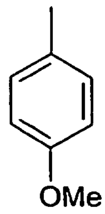

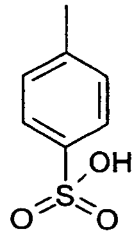

Besonders bevorzugte Reste aus der Gruppe - R4 sind:

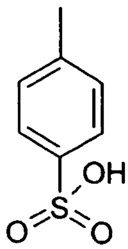

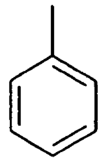

Ganz besonders bevorzugt sind die Monoazo-Farbstoffe der Formeln:

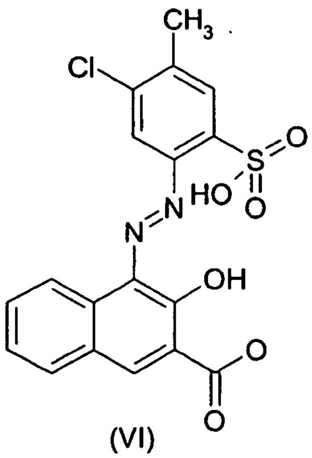

(VI)

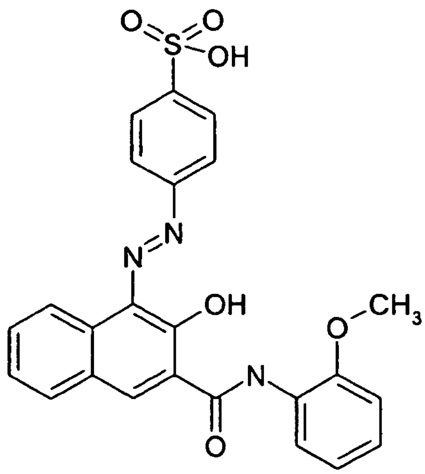

(VII)

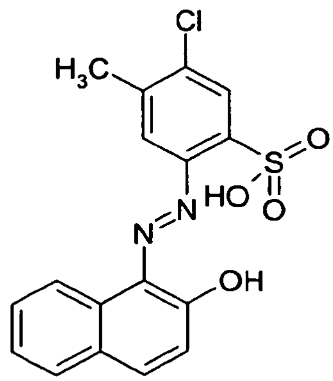

(VIII)

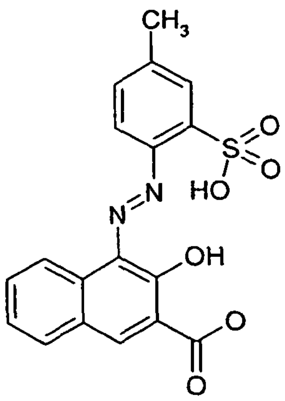

(IX)

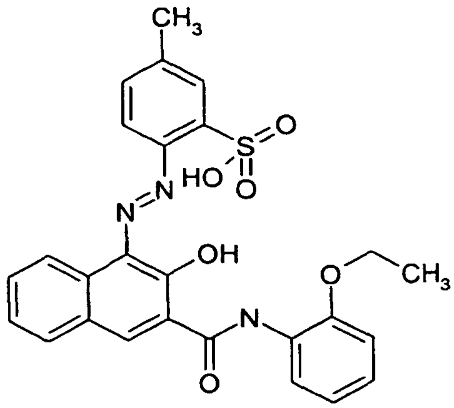

(X)

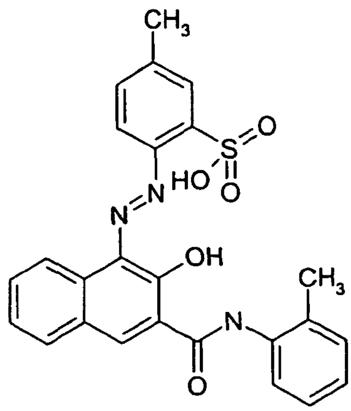

(XI)

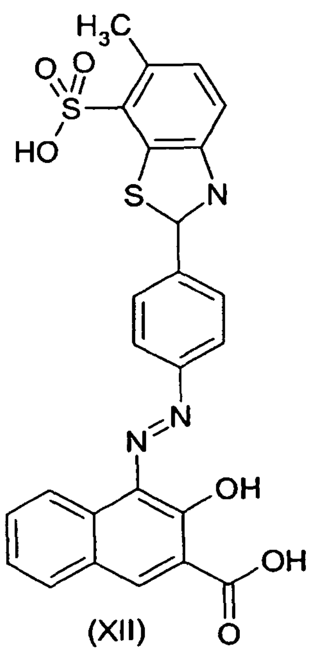

(XII)

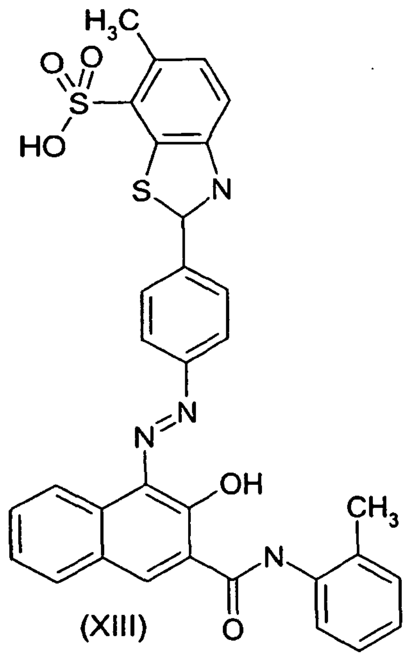

(XIII)

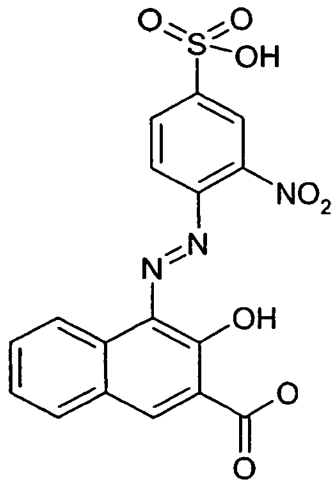

(XIV)

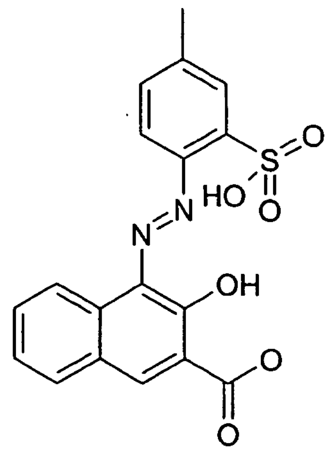

(XV)

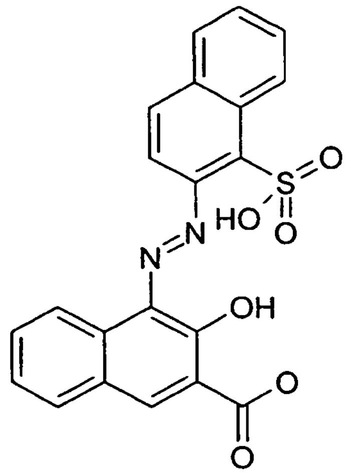

(XVI)

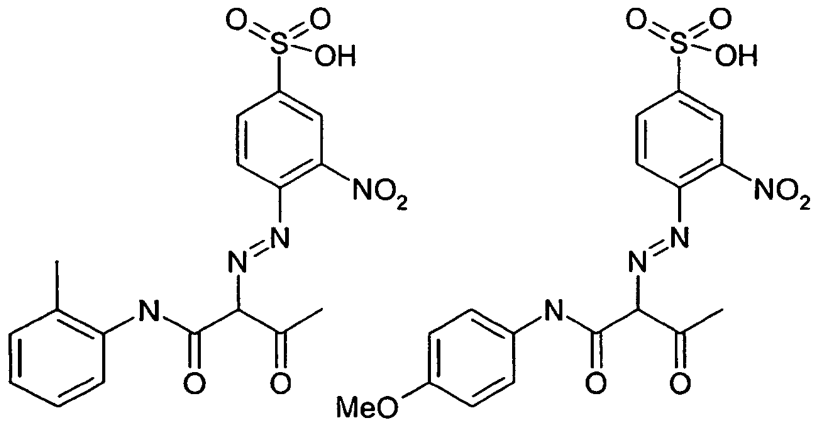

(XVII)

(XVIII)

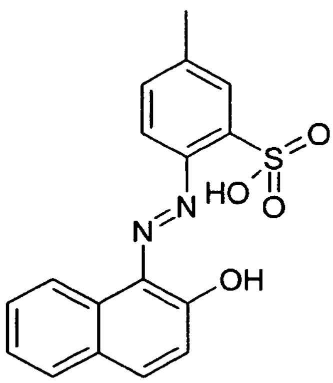

(XIX)

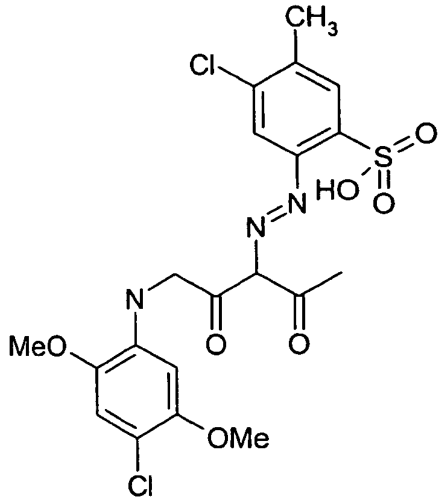

(XX)

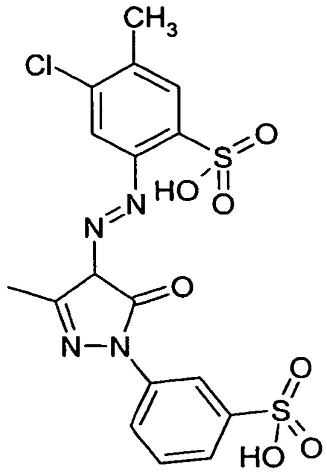

(XXI)

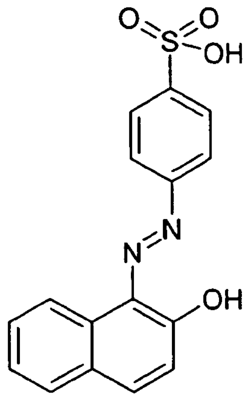

(XXII)

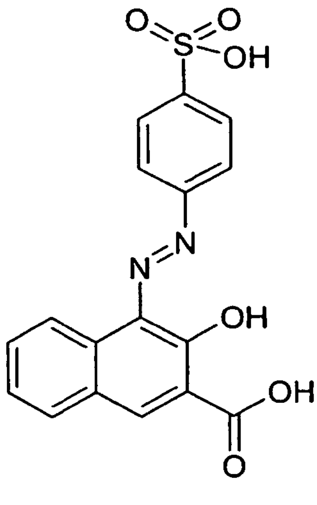

(XXIII)

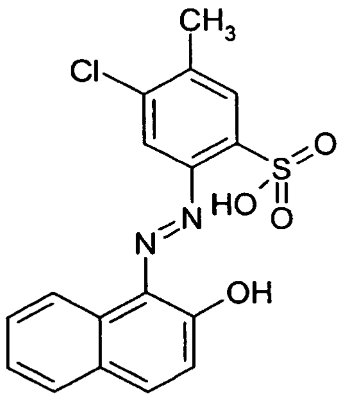

(XXIV)

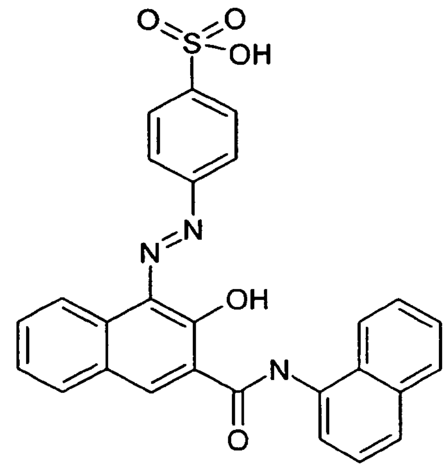

(XXV)

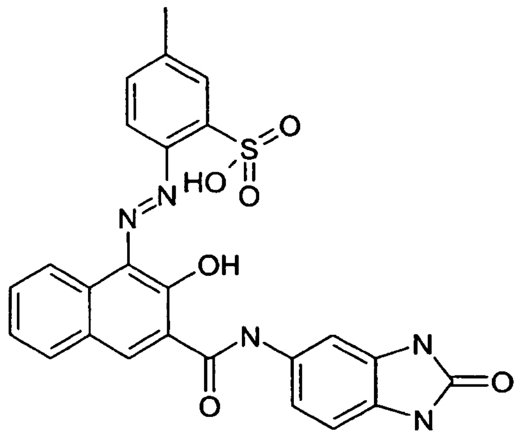

(XXVI)

Die unverlackten, sulfogruppenhaltigen Monoazofarbstoffe sind an sich bekannte Verbindungen und lassen sich nach bekannten Verfahren durch Diazotierung und Azokupplung herstellen.

In bevorzugten Pigmentdispergatoren der Formel (5) bedeuten

- Q ein Rest eines organischen Pigments aus der Gruppe der Chinacridon-, Dioxazin- oder Diketopyrrolopyrrol-Pigmente;
- $R^{30}$ $C_1$-$C_6$-Alkyl, das durch $NR^5R^6$ substituiert ist, wobei $R^5$ und $R^6$ gleich oder verschieden sind und Wasserstoff, Phenyl oder $C_1$-$C_6$-Alkyl bedeuten;
- $R^{40}$ Wasserstoff,
- $G^+$ Wasserstoff, Li, Na, K oder ein Ammoniumion.

In besonders bevorzugten Pigmentdispergatoren der Formel (5) bedeuten

- Q ein Rest eines organischen Pigments aus der Gruppe der Diketopyrrolopyrrol-Pigmente, bevorzugt C.I. Pigment Red 255 oder 264, oder der Chinacridon-Pigmente, bevorzugt C.I. Pigment Violet 19 oder Pigment Red 122;
- $R^{30}$ $C_2$-$C_4$-Alkyl, das durch $NR^5R^6$ substituiert ist, wobei $R^5$ und $R^6$ gleich oder verschieden sind und Wasserstoff oder $C_1$-$C_4$-Alkyl bedeuten;
- $R^{40}$ Wasserstoff,
- $G^+$ Wasserstoff, Li, Na, K oder ein Ammoniumion.

Die Pigmentdispergatoren der Formel (5) sind an sich bekannte Verbindungen und lassen sich nach bekannten Verfahren herstellen, z. B. nach EP-A-1 104 789 oder DE-A-3 106 906.

Die zur Herstellung des Diketopyrrolopyrrol-Pigments zum Einsatz kommenden Ausgangsverbindungen, Lösemittel, Reagenzien und Verfahrensbedingungen sind dem Fachmann bekannt.

Gegenstand der Erfindung ist auch ein Verfahren zur Herstellung der erfindungsgemäßen Pigmentzubereitung, dadurch gekennzeichnet, dass man P.R. 254 während und/oder nach einer Feinverteilung, wie z. B. Knetung, Nassmahlung, Trockenmahlung, oder während und/oder nach einer Finishbehandlung mit dem unverlackten, sulfogruppenhaltigen Monoazofarbstoff und dem Pigmentdispergator der Formel (5) versetzt.
Bevorzugt ist die Zugabe während der Feinverteilung.
Dabei können die jeweiligen Komponenten in trockener Form, wie z. B. in Granulat- oder Pulverform, oder in feuchter Form, wie z. B. als Presskuchen, eingesetzt werden.

Eine bevorzugte Form der Feinverteilung für das P.R. 254 ist die Salzknetung mit einem kristallinen anorganischen Salz in Gegenwart eines organischen Lösemittels.
Als kristallines anorganisches Salz kommen beispielsweise Aluminiumsulfat, Natriumsulfat, Calciumchlorid, Kaliumchlorid oder Natriumchlorid in Betracht, bevorzugt Natriumsulfat, Natriumchlorid und Kaliumchlorid.
Als organisches Lösemittel kommen beispielsweise Ketone, Ester, Amide, Sulfone, Sulfoxide, Nitroverbindungen, Mono-, Bis- oder Tris-hydroxy-$C_2$-$C_{12}$-alkane, die mit $C_1$-$C_8$-alkyl und einer oder mehreren Hydroxygruppen substituiert sein können, in Betracht. Besonders bevorzugt sind mit Wasser mischbare hochsiedende organische Lösemittel auf Basis

von monomeren, oligomeren und polymeren $C_2$-$C_3$-Alkylenglykolen, wie z. B. Diethylenglykol, Diethylenglykolmonomethyl- und ethylether, Triethylenglykol, Triethylenglykolmonomethyl- und ethylether, Dipropylenglykol, Dipropylenglykolmonomethyl- und ethylether, Propylenglykolmonomethyl- und ethylether und flüssige Polyethylen- und Polypropylenglykole, N-Methylpyrrolidon sowie weiterhin Triacetin, Dimethylformamid, Dimethylacetamid, Ethyl-methyl-keton, Cyclohexanon, Diacetonalkohol, Butylacetat, Nitromethan, Dimethylsulfoxid und Sulfolan.
Das Gewichtsverhältnis zwischen dem anorganischen Salz und dem Pigment beträgt bevorzugt (2 bis 10) zu 1, insbesondere (3 bis 7) zu 1.
Das Gewichtsverhältnis zwischen dem organischen Lösemittel und dem anorganischen Salz beträgt bevorzugt (1 ml : 10 g) bis (2 ml : 7 g).
Das Gewichtsverhältnis zwischen dem organischen Lösemittel und der Summe aus anorganischem Salz und Pigment beträgt bevorzugt (1 ml : 2 g) bis (1 ml : 10 g).
Die Temperatur während der Knetung kann zwischen 40 und 140 °C, vorzugsweise 60 bis 120 °C, betragen. Die Knetdauer beträgt zweckmäßigerweise 4 h bis 32 h, bevorzugt 8 h bis 20 h.
Nach der Salzknetung wird das anorganische Salz und das organische Lösemittel zweckmäßigerweise durch Waschen mit Wasser entfernt und die so erhaltene Pigmentkomposition nach üblichen Verfahren getrocknet.

Das nach der erfindungsgemäßen Feinverteilung erhaltene Material kann als Suspension, Filterkuchen oder trockenes Material gegebenenfalls einer Lösungsmittelnachbehandlung unterzogen werden, um eine homogenere Teilchenform zu erhalten, ohne die Teilchengröße merklich zu erhöhen. Bevorzugt ist die Verwendung von Wasser oder wasserdampfflüchtigen Lösungsmitteln wie Alkoholen und aromatischen Lösungsmitteln, besonders bevorzugt verzweigte oder unverzweigte $C_1$-$C_6$-Alkohole, Toluol, Xylol, Chlorbenzol, Dichlorbenzol, Nitrotoluol oder Nitrobenzol meist unter erhöhter Temperatur, beispielsweise bis 200 °C, und gegebenenfalls unter erhöhtem Druck.

Es ist auch möglich, einen oder mehrere der genannten Verfahrensschritte zur Herstellung der erfindungsgemäßen Pigmentzubereitungen in einem Mikroreaktor durchzuführen.

Die erfindungsgemäße Pigmentzubereitung kann noch weitere übliche Hilfsmittel oder Zusatzstoffe enthalten, wie beispielsweise Tenside, Dispergiermittel, Füllstoffe, Stellmittel, Harze, Wachse, Entschäumer, Antistaubmittel, Extender, Antistatika, Konservierungsmittel, Trocknungsverzögerungsmittel, Netzmittel, Antioxidantien, UV-Absorber und Lichtstabilisatoren, vorzugsweise in einer Menge von 0,1 bis 15 Gew.-%, insbesondere 0,5 bis 10 Gew.-%, bezogen auf das Gesamtgewicht der Pigmentzubereitung.

Als Tenside kommen übliche anionische, kationische, nichtionische oder amphotere Substanzen oder Mischungen dieser Mittel in Betracht.

Die erfindungsgemäßen Pigmentzubereitungen lassen sich prinzipiell zum Pigmentieren von allen hochmolekularen organischen Materialien natürlicher oder synthetischer Herkunft einsetzen, beispielsweise von Kunststoffen, Harzen, Lacken, insbesondere Metallic-Lacken, Anstrichfarben, elektrophotographischen Tonern und Entwicklern, Elektretmaterialien, Farbfiltern sowie von Tinten, Druckfarben.
Insbesondere lassen sich mit den erfindungsgemäßen Pigmentzubereitungen Farbtöne im roten Bereich erzielen, die beim Einsatz in Farbfiltern gefragt sind. Hier sorgen sie für hohen Kontrast und für steile und schmale Absorptionsbanden. Insbesondere sind die erfindungsgemäßen Pigmentzubereitungen auch als Farbmittel in Ink-Jet Tinten auf wässriger und nichtwässriger Basis sowie in solchen Tinten, die nach dem Hot-melt-Verfahren arbeiten, geeignet.

Gegenstand der vorliegenden Erfindung ist daher auch ein hochmolekulares organisches Material, enthaltend eine färberisch wirksame Menge einer erfindungsgemäßen Pigmentzubereitung.
Bezogen auf das zu pigmentierende, hochmolekulare organische Material setzt man die erfindungsgemäße Pigmentzubereitung meist in einer Menge von 0,01 bis 30 Gew.-%, vorzugsweise 0,1 bis 15 Gew.-%, ein. Bei dem Einsatz in Farbfiltern können auch höhere Mengen eingesetzt werden, wie nachstehend erwähnt.

Insbesondere sind die erfindungsgemäßen Pigmentzubereitungen als Farbmittel für Farbfilter sowohl für die additive wie auch für die subtraktive Farberzeugung geeignet, wie beispielsweise in elektro-optischen Systemen wie Fernsehbildschirmen, LCD (liquid crystal displays), charge coupled devices, plasma displays oder electroluminescent displays, die wiederum aktive (twisted nematic) oder passive (supertwisted nematic) ferroelectric displays oder lightemitting diodes sein können, sowie als Farbmittel für elektronische Tinten ("electronic inks" bzw. "e-inks") oder ‚electronic paper" ("e-paper").

Bei der Herstellung von Farbfiltern, sowohl reflektierender wie durchsichtiger Farbfilter, werden Pigmente in Form einer Paste oder als pigmentierte Photoresists in geeigneten Bindemitteln (Acrylate, Acrylester, Polyimide, Polyvinylalkohole, Epoxide, Polyester, Melamine, Gelatine, Caseine) auf die jeweiligen LCD-Bauteilen (z. B. TFT-LCD = Thin Film Transistor Liquid Crystal Displays oder z. B. ((S) TN-LCD = (Super) Twisted Nematic-LCD) aufgebracht. Darüber hinaus können die pigmentierten Color Filter auch durch Ink Jet-Druckverfahren oder andere geeignete Druckverfahren aufgebracht werden.

Die Rotfarbtöne der erfindungsgemäßen Pigmentzubereitungen sind ganz besonders gut geeignet für den Color Filter Farbset Rot-Grün-Blau (R,G,B). Diese drei Farben liegen als getrennte Farbpunkte nebeneinander vor, und ergeben von hinten durchleuchtet ein Vollfarbbild.

Typische Farbmittel für den blauen Farbpunkt sind Phthalocyaninfarbmittel oder Benzimidazolondioxazinpigmente wie z. B. C.I. Pigment Blue 15:6 und C.I.

Pigment Blue 80. Für den grünen Farbpunkt werden typischerweise Phthalocyaninfarbmittel eingesetzt, wie z. B. C.I. Pigment Green 36 und C.I. Pigment Green 7. Der Rotfarbton wird bevorzugt abgemischt aus P.R. 254 und P.R. 177 oder aus P.R. 254 und P.R. 242.

Bei Bedarf können den jeweiligen Farbpunkten noch weitere Farben zum Nuancieren zugemischt werden. Für den Rot- und Grünfarbton wird bevorzugt mit Gelb abgemischt, zum Beispiel mit C.I. Pigment Yellow 138,139,150,151,180 und 213. Für den Blau Farbton wird bevorzugt mit Violet abgemischt, z. B. mit C.I. Pigment Violet 19 oder 23.

Die Einsatzkonzentration der erfindungsgemäßen Pigmentzubereitung im aufgebrachten Color Filter-Film kann zwischen 5 und 95 Gew.-%, bevorzugt zwischen 20 und 80 Gew.-%, ganz besonders bevorzugt zwischen 40 und 60 Gew.-%, liegen, bezogen auf das Gesamtgewicht des Color Filter-Filmes. Gegenstand der Erfindung ist auch ein Farbfilter, enthaltend eine färberisch wirksame Menge der erfindungsgemäßen Pigmentzubereitung.

In den folgenden Beispielen bedeuten Prozentangaben Gewichtsprozente und Teile Gewichtsteile, sofern nicht anders angegeben.

Beispiel A: Dispergator (VI)

a) Diazo (Mischung 1):

89,6 Teile 2-Amino-4-chlor-5-methylbenzolsulfonsäure werden in 400 Teilen Wasser und 41 Teilen Natronlauge (w = 33 %) gelöst. Es wird mit 162 Teilen Salzsäure (w = 31 %) und 73 Teilen Natriumnitritlösung (w = 40 %) bei 10°C diazotiert. Anschließend wird durch Zugabe von 50 Teilen Natriumacetat ein pH von 3-4 eingestellt.

b) Kuppler (Mischung 2):

In 1600 Teilen Wasser und 98 Teilen Natronlauge 33 %ig werden 79 Teile BONS (3-Hydroxy-naphthalin-2-carbonsäure) gelöst. Durch Zugabe von Eis wird auf 10°C abgekühlt.

c) Kupplung:

Mischung 1 wird in 90 Minuten bei 15 °C zu Mischung 2 gegeben. Es wird erst eine Stunde bei 30°C, dann eine Stunde bei 60°C gerührt. Die entstehende tiefrote Suspension wird filtriert, gewaschen und bei 80 °C im Umlufttrockenschrank getrocknet. Man erhält 160 Teile des Dispergators (VI).

Beispiele B bis U:

Analog Beispiel A werden die Dispergatoren (VII) bis (XXVI) hergestellt.

Beispiel 1:

PV Echtrot D3G (Clariant) wird einer Salzknetung unterzogen. Dafür werden 14 g des trockenen Pigments, 1,4 g des Pigmentdispergators (27), hergestellt in Anlehnung an EP-A-1 104 789, Beispiel 10a, und 1,4 g des Dispergators (VI) mit 90 g Natriumchlorid und 22 ml Diethylenglykol bei einer Temperatur von 80°C für 24 h geknetet. Der Knetteig wird in 0,9 l 5 %iger Salzsäure für zwei Stunden gerührt und das Pigment anschließend abfiltriert.

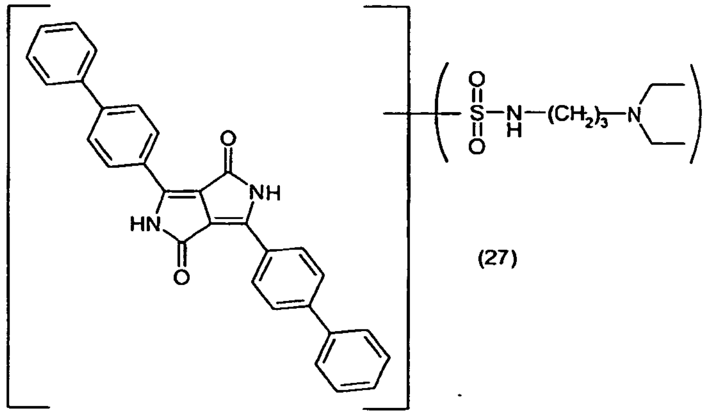

s ca. 1,7

(27)

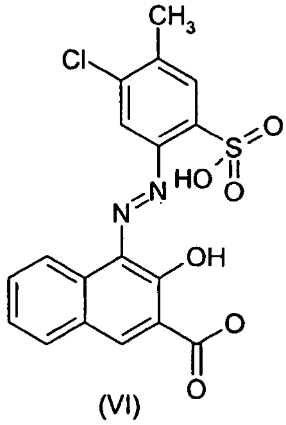

(VI)

Der Filterkuchen wird erneut für 1 h unter Rühren mit 0,9 l entsalztem Wasser behandelt. Nach der Filtration wird das Pigment mit Wasser salz- und säurefrei gewaschen und im Vakuum getrocknet.

Beispiel 2:

Analog zu Beispiel 1 werden 1,4 g des Pigmentdispergators (27) und 1,4 g des Dispergators (VII) in die Knetung eingesetzt. Man erhält eine rote Pigmentzusammensetzung.

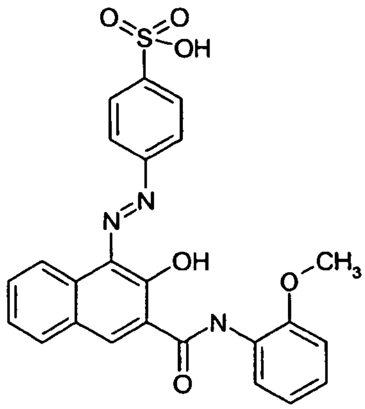

(VII)

Beispiel 3:

Analog zu Beispiel 1 werden 1,4 g des Pigmentdispergators (27) und 1,4 g des Dispergators (XI) in die Knetung eingesetzt. Man erhält eine rote Pigmentzusammensetzung.

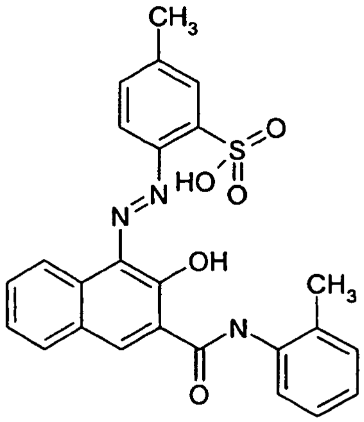

(XI)

Beispiel 4:

Analog zu Beispiel 1 werden 1,4 g des Pigmentdispergators (27) und 1,4 g des Dispergators (XIII) in die Knetung eingesetzt. Man erhält eine rote Pigmentzusammensetzung.

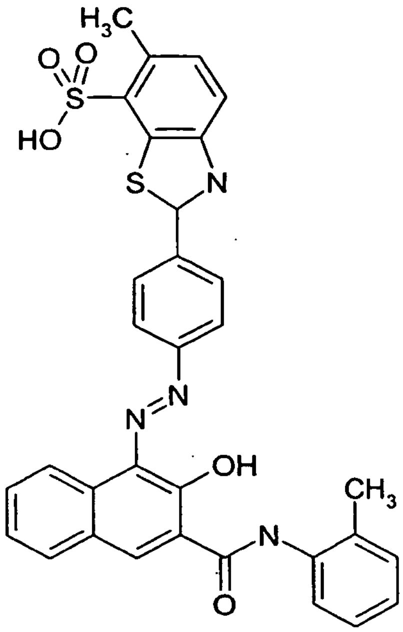

(XIII)

Beispiel 5:

Analog zu Beispiel 1 werden 1,4 g des Pigmentdispergators (27) und 1,4 g des Dispergators (XIV) in die Knetung eingesetzt. Man erhält eine rote Pigmentzusammensetzung.

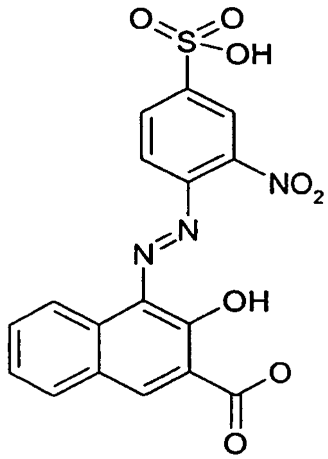

(XIV)

Beispiel 6:

Analog zu Beispiel 1 werden 1,4 g des Pigmentdispergators (27) und 1,4 g des Dispergators (XIX) in die Knetung eingesetzt. Man erhält eine rote Pigmentzusammensetzung.

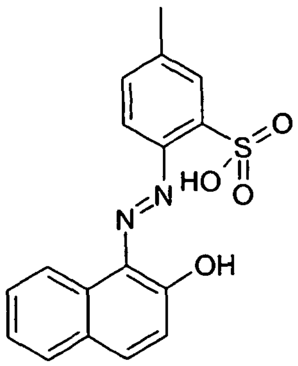

(XIX)

Beispiel 7:

Analog zu Beispiel 1 werden 1,4 g des Pigmentdispergators (27) und 1,4 g des Dispergators (XX) in die Knetung eingesetzt. Man erhält eine rote Pigmentzusammensetzung.

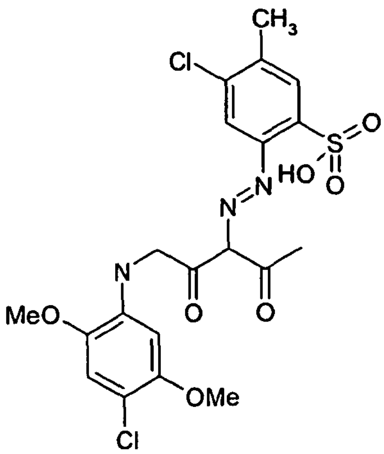

(XX)

Beispiel 8:

Analog zu Beispiel 1 werden 1,4 g des Pigmentdispergators (27) und 1,4 g des Dispergators (XXIV) in die Knetung eingesetzt. Man erhält eine rote Pigmentzusammensetzung.

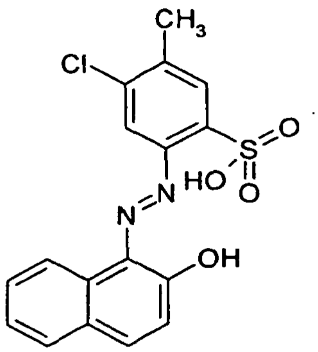

(XXIV)

Beispiel 9:

In eine Salzknetung analog Beispiel 1 werden 1,4 g des Pigmentdispergators (28), hergestellt in Anlehnung an EP-A-3 106 906, Beispiel 1, und 1,4 g des Dispergators (VI) eingesetzt. Man erhält eine rote Pigmentzusammensetzung.

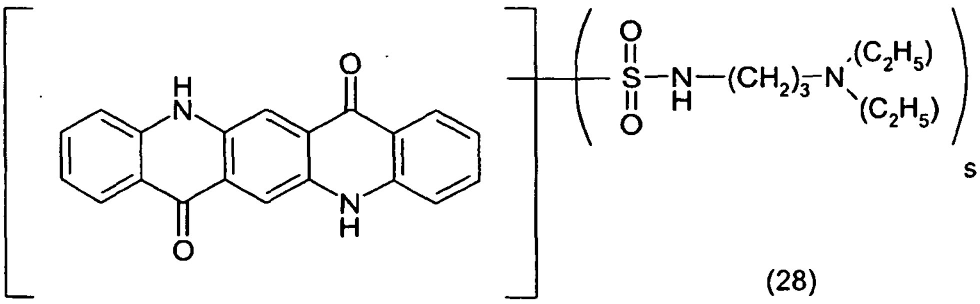

s ca. 2

(28)

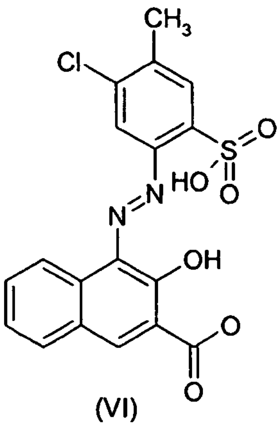

(VI)

Beispiel 10:

Analog Beispiel 9 werden 1,4 g des Pigmentdispergators (28) und 1,4 g des Dispergators (VII) in die Knetung eingesetzt. Man erhält eine rote Pigmentzusammensetzung.

Beispiel 11:

Analog zu Beispiel 9 werden 1,4 g des Pigmentdispergators (28) und 1,4 g des Dispergators (X) in die Knetung eingesetzt. Man erhält eine rote Pigmentzusammensetzung.

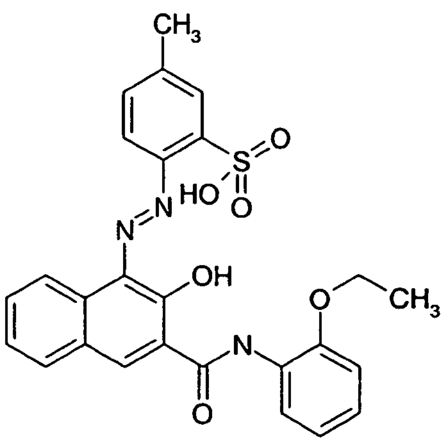

(X)

Beispiel 12:

Analog zu Beispiel 9 werden 1,4 g des Pigmentdispergators (28) und 1,4 g des Dispergators (XV) in die Knetung eingesetzt. Man erhält eine rote Pigmentzusammensetzung.

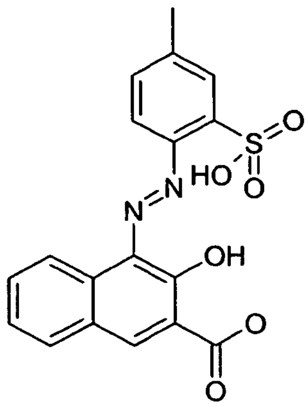

(XV)

Beispiel 13:

Analog zu Beispiel 9 werden 1,4 g des Pigmentdispergators (28) und 1,4 g des Dispergators (XXIII) in die Knetung eingesetzt. Man erhält eine rote Pigmentzusammensetzung.

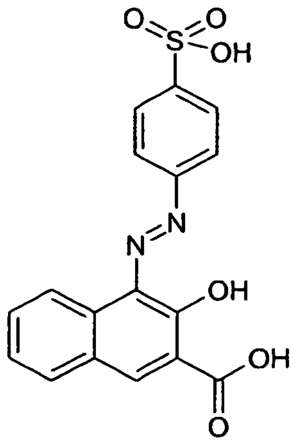

(XXIII)

Beispiel 14:

Analog zu Beispiel 1 werden 0,7 g des Pigmentdispergators (27) und 0,7 g des Dispergators (VI) in die Knetung eingesetzt. Man erhält eine rote Pigmentzusammensetzung.

Beispiel 15:

Analog zu Beispiel 1 werden 2,1 g des Pigmentdispergators (27) und 2,1 g des Dispergators (VI) in die Knetung eingesetzt. Man erhält eine rote Pigmentzusammensetzung.

Vergleichsbeispiel 1:

Analog zu Beispiel 1 werden nur die 1,4 g des Dispergators (VI) in die Knetung eingesetzt. Man erhält eine rote Pigmentzusammensetzung.

Vergleichsbeispiel 2:

Analog zu Beispiel 2 werden nur die 1,4 g des Dispergators (VII) in die Knetung eingesetzt. Man erhält eine rote Pigmentzusammensetzung.

Anwendung in Colorfiltern:

7,6 g Pigment bzw. Pigmentzusammensetzung werden mit 1,8 g Solsperse 24000 (Avecia) und 42 g PGMEA versetzt. Nach Zugabe von 122 g Zirkonoxid-Perlen (0,5 - 0,7 mm) wird für zwei Stunden im Paint Shaker dispergiert. Die so erhaltene Millbase wird mit einem Kegel-Platte Viskosimeter Haake RS75 bei 20 °C vermessen (DIN 53019, Bestimmung der Viskosität und der Thixotrophie). Zu der erhaltenen Millbase wird eine Mischung aus 7,2 g Joncryl® 611 (Styrol-Acrylatharz, Johnson Polymers) in 13,4 g PGMEA gegeben und erneut für 10 Minuten im Paintshaker dispergiert. Die Pigmentdispersion wird mit Hilfe eines Spincoaters (POLOS Wafer Spinner) auf Glasplatten (SCHOTT, Laser-geschnitten, 10 x 10 cm) aufgetragen und der Kontrastwert (Goniometer DMS 803, Spektrograph CCD-SPECT2) gemessen.

| Probe | Viskosität/ mPas | Viskosität / 5 Tage mPas | Thixotropie/ Pas | Kontrastwert |
|---|---|---|---|---|
| Beispiel 1 | 16 | 21 | 4 | 2741 |
| Beispiel 2 | 22 | 37 | 2 | 2806 |
| Beispiel 3 | 35 | 42 | 5 | 2413 |
| Beispiel 4 | 46 | 50 | 10 | 2566 |
| Beispiel 5 | 21 | 25 | 8 | 2745 |
| Beispiel 6 | 33 | 45 | 11 | 2231 |
| Beispiel 7 | 28 | 34 | 3 | 2347 |
| Beispiel 8 | 51 | 56 | 7 | 2563 |
| Beispiel 9 | 19 | 35 | 17 | 2617 |
| Beispiel 10 | 27 | 38 | 3 | 2165 |
| Beispiel 11 | 33 | 43 | 4 | 2445 |
| Beispiel 12 | 23 | 26 | 13 | 2391 |
| Beispiel 13 | 27 | 34 | 2 | 2677 |
| Beispiel 14 | 65 | 79 | 22 | 2215 |
| Beispiel 15 | 12 | 20 | 3 | 2834 |
| Vergleichsbeispiel 1 | 88 | 179 | 3462 | 1819 |
| Vergleichsbeispiel 2 | 50 | 146 | 2045 | 2034 |

Die Pigmentzusammensetzungen aus Beispielen 1 bis 15 sind aufgrund ihres hohen Kontrastwertes und der niedrigen Viskosität und Thixotropie der Millbase für Colorfilteranwendungen sehr gut geeignet.

**Patentansprüche**

1. Pigmentzubereitung, enthaltend

(a) C.I. Pigment Red 254 einer mittleren Teilchengröße $d_{50}$ von höchstens 100 nm;

(b) 0,1 bis 30 Gew.-%, bezogen auf das Gewicht des PR 254, eines oder mehrerer Dispergatoren aus der Gruppe der unverlackten, sulfogruppenhaltigen Monoazofarbstoffe der Formel (I), (II), (III) oder (IV)

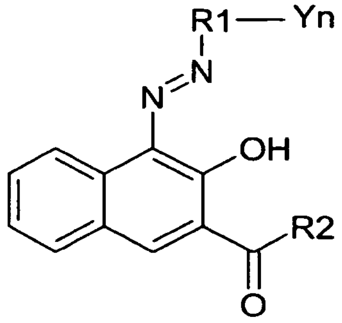

(I)

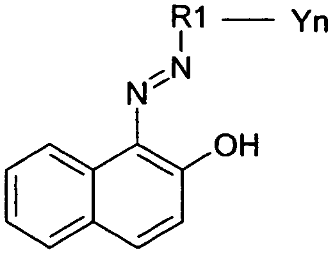

(II)

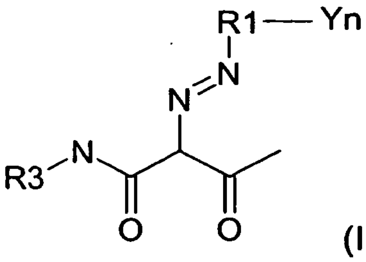

(III)

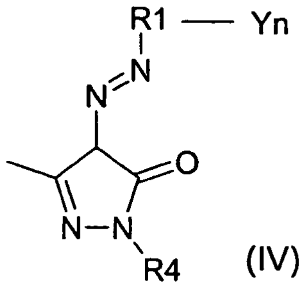

(IV)

worin

R1 ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon; wobei die genannten Aromaten- und Heteroaromaten-Reste durch 1, 2, 3 oder 4 Substituenten aus der Gruppe OH, CN, F, Cl, Br, $NO_2$, $CF_3$, $C_1$-$C_6$-Alkoxy, S-$C_1$-$C_6$-Alkyl, $NHCONH_2$, $NHC(NH)NH_2$, NHCO-$C_1$-$C_6$-Alkyl, $C_1$-$C_6$-Alkyl, COOR5, CONR5R6, $SO_3R5$, $SO_2$-NR5R6 oder $COO^-E^+$ substituiert sein können, wobei R5 und R6 gleich oder verschieden sind und Wasserstoff, Phenyl oder $C_1$-$C_6$-Alkyl und $E^+$ Wasserstoff, Lithium, Natrium, Kalium, Rubidium, Cäsium oder ein unsubstituiertes Ammoniumion bedeuten;

Y $SO_3^-$ $E^+$ oder Z-$SO_3^-$ $E^+$, wobei Z $C_1$ - $C_{10}$-Alkylen oder Phenylen bedeutet;

n die Zahl von 1, 2 oder 3;

R2 -$OR^8$ oder -$NHR^8$, wobei $R^8$ die Bedeutung H, $C_1$-$C_6$-Alkyl, Benzyl, ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon hat; wobei die genannten Aromaten- und Heteroaromaten-Reste jeweils durch 1, 2, 3 oder 4 Substituenten aus der Gruppe OH, $C_1$-$C_6$-Alkoxy, S-$C_1$-$C_6$- Alkyl, Halogen, $NHCONH_2$, $NHC(NH)NH_2$, NHCO-$C_1$-$C_6$-Alkyl, $C_1$-$C_6$-Alkyl, Nitro, COOR5, CONR5R6, $SO_3R5$, $SO_2$-NR5R6, $SO_3^-E^+$ oder $COO^-E^+$ substituiert sein können, wobei R5 und R6 gleich oder verschieden sind und Wasserstoff, Phenyl oder $C_1$-$C_6$-Alkyl bedeuten;

R3 und R4 jeweils ein aromatischer Rest mit 1, 2 oder 3 aromatischen Ringen, wobei die Ringe kondensiert vorliegen oder durch eine Bindung verknüpft sein können, oder ein heterocyclischer Rest mit 1, 2 oder 3 Ringen, enthaltend 1, 2, 3 oder 4 Heteroatome aus der Gruppe O, N und S; oder eine Kombination davon; wobei die genannten Aromaten- und Heteroaromaten-Reste jeweils durch 1, 2, 3 oder 4 Substituenten aus der Gruppe OH, $C_1$-$C_6$-Alkoxy, S-$C_1$-$C_6$- Alkyl, Halogen, $NHCONH_2$, $NHC(NH)NH_2$, NHCO-$C_1$-$C_6$-Alkyl, $C_1$-$C_6$-Alkyl, Nitro, COOR5, CONR5R6, $SO_3R5$, $SO_2$-NR5R6, $SO_3^-E^+$ oder $COO^-E^+$ substituiert sein können, wobei R5 und R6 gleich oder verschieden sind und Wasserstoff, Phenyl oder $C_1$-$C_6$-Alkyl bedeuten;

(c) 0,1 bis 30 Gew.-%, bezogen auf das Gewicht des PR 254, eines basischen Pigmentdispergators der Formel (5)

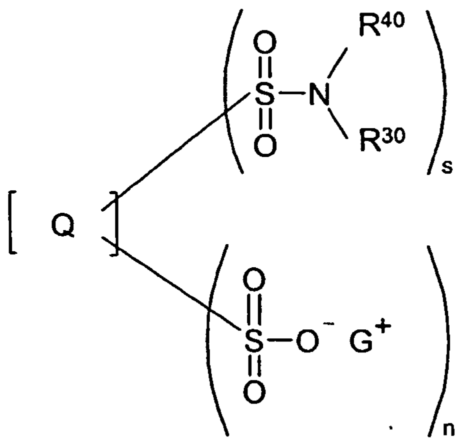

(5)

worin

Q ein Rest eines organischen Pigments aus der Gruppe der Perinon-, Chinacridon-, Chinacridonchinon-, Anthanthron-, Indanthron-, Dioxazin-, Diketopyrrolopyrrol-, Indigo-, Thioindigo-, Thiazinindigo-, Isoindolin-, Isoindolinon-, Pyranthron-, Isoviolanthron-, Flavanthron- oder Anthrapyrimidin-Pigmente ist;
s eine Zahl von 1 bis 5 darstellt;
n eine Zahl von 0 bis 4 darstellt; wobei die Summe von s und n 1 bis 5 beträgt und s größer als n ist;
$R^{30}$ einen verzweigten oder unverzweigten, gesättigten oder ungesättigten, aliphatischen Kohlenwasserstoffrest mit 1 bis 20 C-Atomen, oder einen $C_5$-$C_7$-Cycloalkylrest, oder einen araliphatischen oder aromatischen Rest mit 1, 2 oder 3 aromatischen Ringen, wobei die Ringe kondensiert vorliegen oder durch eine Bindung verknüpft sein können, oder einen heterocyclischen Rest mit 1, 2 oder 3 Ringen, enthaltend 1, 2, 3 oder 4 Heteroatome aus der Gruppe O, N und S, oder eine Kombination davon bedeutet; wobei die genannten Kohlenwasserstoff-, Cycloalkyl-, Aromaten-, Araliphaten- und Heteroaromaten-Reste durch 1, 2, 3 oder 4 Substituenten aus der Gruppe OH, CN, F, Cl, Br, $NO_2$, $CF_3$, $C_1$-$C_6$-Alkoxy, S-$C_1$-$C_6$-Alkyl, $NHCONH_2$, $NHC(NH)NH_2$, NHCO-$C_1$-$C_6$-Alkyl, $C_1$-$C_6$-Alkyl, $CONR^5R^6$, $NR^5R^6$, $SO_2$-$NR^5R^6$ substituiert sein können, wobei $R^5$ und $R^6$ gleich oder verschieden sind und Wasserstoff, Phenyl oder $C_1$-$C_6$-Alkyl bedeuten, mit der Maßgabe, dass in den genannten Kohlenwasserstoff-, Cycloalkyl-, Aromaten-, Araliphaten- oder Heteroaromaten-Resten mindestens eine basische Aminogruppe enthalten ist;
$R^{40}$ Wasserstoff oder $R^{30}$ bedeutet;
$G^+$ die Bedeutung $H^+$, Alkalimetall oder substituiertes oder unsubstituiertes Ammoniumion hat.

2. Pigmentzubereitung nach Anspruch 1, **dadurch gekennzeichnet, dass**

Q ein Rest von C.I. Pigment Red 255 oder von C.I. Pigment Red 264 oder von C.I. Pigment Violet 19 oder von Pigment Red 122;
$R^{30}$ $C_2$-$C_4$-Alkyl, das durch $NR^5R^6$ substituiert ist, wobei $R^5$ und $R^6$ gleich oder verschieden sind und Wasserstoff oder $C_1$-$C_4$-Alkyl bedeuten;
$R^{40}$ Wasserstoff,
$G^+$ Wasserstoff, Li, Na, K oder ein Ammoniumion ist.

3. Pigmentzubereitung nach Anspruch 1 oder 2, **dadurch gekennzeichnet, dass** der Rest R2 OH oder O-$C_1$-$C_6$-Alkyl bedeutet.

4. Pigmentzubereitung nach Anspruch 1 oder 2, **dadurch gekennzeichnet, dass** der Rest -CO-R2 eine Amidgruppe mit R2 gleich $NH_2$,

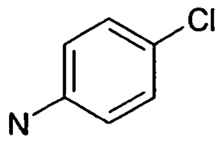
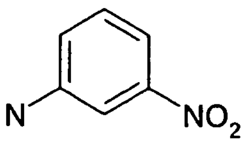
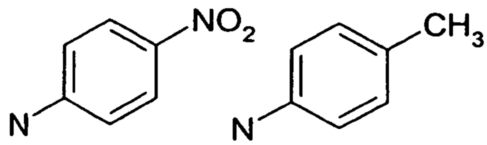

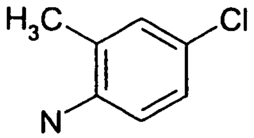
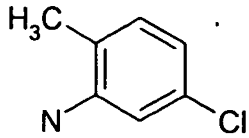
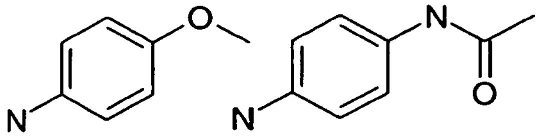

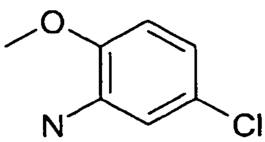
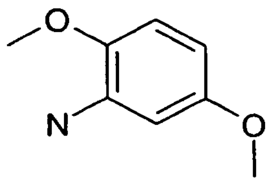
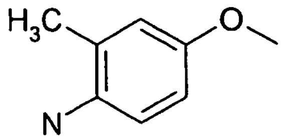

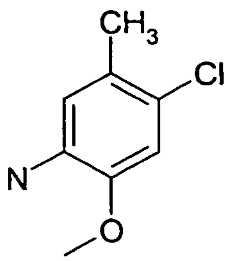
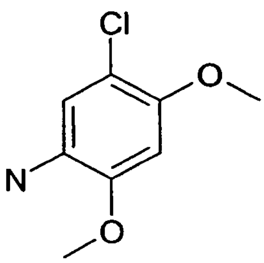
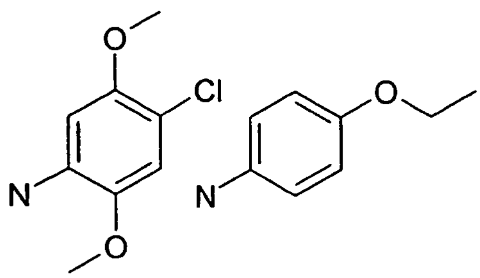

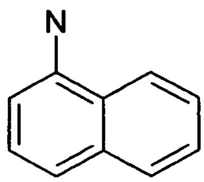
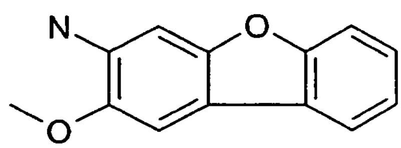
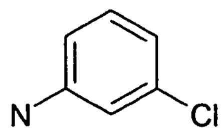

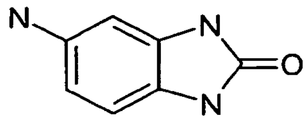

bedeutet, wobei in den vorstehenden Formeln die Bindung zur Carbonylgruppe über die freie Aminogruppe N - des Aromatenringes erfolgt.

5. Pigmentzubereitung nach einem oder mehreren der Ansprüche 1 bis 4, **dadurch gekennzeichnet, dass** das Gewichtsverhältnis der Komponenten b) und c) zueinander etwa 1 : 1 ist.

6. Verfahren zur Herstellung einer Pigmentzubereitung nach einem oder mehreren der Ansprüche 1 bis 5, **dadurch gekennzeichnet, dass** man P.R. 254 während und/oder nach einer Feinverteilung, oder während und/oder nach einer Finishbehandlung mit dem unverlackten, sulfogruppenhaltigen Monoazofarbstoff und dem Pigmentdispergator der Formel (5) versetzt.

7. Verwendung einer Pigmentzubereitung nach einem oder mehreren der Ansprüche 1 bis 5 zum Pigmentieren von Kunststoffen, Harzen, Lacken, insbesondere Metallic-Lacken, Anstrichfarben, elektrophotographischen Tonern und Entwicklern, Elektretmaterialien, Farbfiltern sowie von Tinten, insbesondere Inkjet-Tinten, Druckfarben.

8. Farbfilter, enthaltend eine färberisch wirksame Menge einer Pigmentzubereitung nach einem oder mehreren der Ansprüche 1 bis 5.

**Claims**

1. A pigment preparation comprising

(a) C.I. Pigment Red 254 with an average particle size $d_{50}$ of not more than 100 nm;
(b) 0.1% to 30% by weight, based on the weight of the PR 254, of one or more dispersants from the group of the unlaked sulfo-containing monoazo dyes of the formula (I), (II), (III) or (IV)

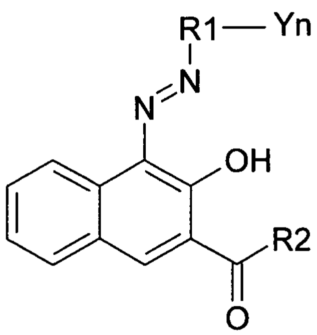
(I)

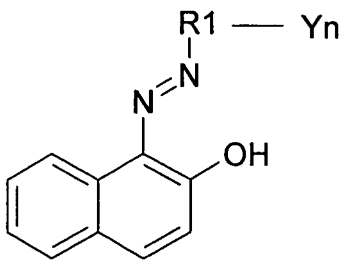
(II)

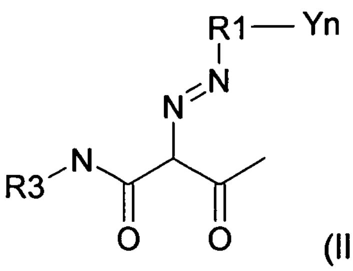
(III)

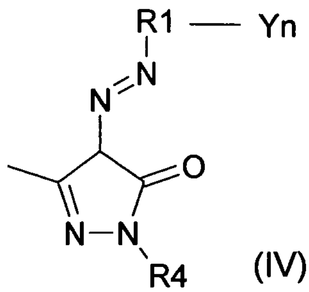
(IV)

in which

R1 is an aromatic radical having 1, 2 or 3 aromatic rings, it being possible for the rings to be fused or to be linked by a bond, or a heterocyclic radical having 1, 2 or 3 rings containing 1, 2, 3 or 4 heteroatoms from the group consisting of O, N, and S; or a combination thereof; it being possible for the stated aromatic and heteroaromatic radicals to be substituted by 1, 2, 3 or 4 substituents from the group consisting of OH, CN, F, Cl, Br, $NO_2$, $CF_3$, $C_1$-$C_6$-alkoxy, S-$C_1$-$C_6$- alkyl, $NHCONH_2$, NHC (NH) $NH_2$, NHCO-$C_1$-$C_6$-alkyl, $C_1$-$C_6$-alkyl, COOR5, CONR5R6, $SO_3R5$, $SO_2$-NR5R6 or $COO^-E^+$, R5 and R6 being alike or different and being hydrogen, phenyl or $C_1$-$C_6$-alkyl , and $E^+$ being hydrogen, lithium, sodium, potassium, rubidium, cesium or

an unsubstituted ammonium ion;

Y is $SO_3\ E^+$ or $Z\text{-}SO_3^-E^+$, Z being $C_1$ - $C_{10}$-alkylene or phenylene;

n is a number 1, 2 or 3;

R2 is $-OR^8$ or $-NHR^8$, where $R^8$ has the definition H, $C_1$-$C_6$-alkyl, benzyl, an aromatic radical having 1, 2 or 3 aromatic rings, it being possible for the rings to be fused or to be linked by a bond, or a heterocyclic radical having 1, 2 or 3 rings containing 1, 2, 3 or 4 heteroatoms from the group consisting of O, N, and S; or a combination thereof; it being possible for the stated aromatic and heteroaromatic radicals to be substituted in each case by 1, 2, 3 or 4 substituents from the group consisting of OH, $C_1$-$C_6$-alkoxy, S-$C_1$-$C_6$-alkyl, halogen, $NHCONH_2$, $NHC(NH)NH_2$, NHCO-$C_1$-$C_6$-alkyl, $C_1$- $C_6$-alkyl, nitro, COOR5, CONR5R6, $SO_3R5$, $SO_2$-NR5R6, $SO_3^-E^+$ or $COO^-E^+$, R5 and R6 being alike or different and being hydrogen, phenyl or $C_1$-$C_6$-alkyl;

R3 and R4 are each an aromatic radical having 1, 2 or 3 aromatic rings, it being possible for the rings to be fused or to be linked by a bond, or a heterocyclic radical having 1, 2 or 3 rings containing 1, 2, 3 or 4 heteroatoms from the group consisting of O, N, and S; or a combination thereof; it being possible for the stated aromatic and heteroaromatic radicals to be substituted in each case by 1, 2, 3 or 4 substituents from the group consisting of OH, $C_1$-$C_6$-alkoxy, S-$C_1$-$C_6$-alkyl, halogen, $NHCONH_2$, NHC (NH) $NH_2$, NHCO-$C_1$-$C_6$-alkyl, $C_1$- $C_6$-alkyl, nitro, COOR5, CONR5R6, $SO_3R5$, $SO_2$-NR5R6, $SO_3^-E^+$ or $COO^-E^+$, R5 and R6 being alike or different and being hydrogen, phenyl or $C_1$-$C_6$-alkyl;

(c) 0.1% to 30% by weight, based on the weight of the PR 254, of a basic pigment dispersant of the formula (5)

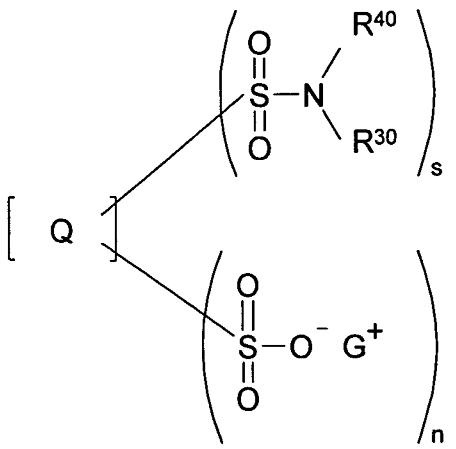

(5)

in which

Q is a radical of an organic pigment from the group of the perinone, quinacridone, quinacridonequinone, anthanthrone, indanthrone, dioxazine, diketopyrrolopyrrole, indigo, thioindigo, thiazineindigo, isoindoline, isoindolinone, pyranthrone, isoviolanthrone, flavanthrone or anthrapyrimidine pigments;

s is a number from 1 to 5;

n is a number from 0 to 4; the sum of s and n is 1 to 5, and s is greater than n;

$R^{30}$ is a branched or unbranched, saturated or unsaturated, aliphatic hydrocarbon radical having 1 to 20 carbon atoms, or a $C_5$-$C_7$-cycloalkyl radical, or an araliphatic or aromatic radical having 1, 2 or 3 aromatic rings, it being possible for the rings to be fused or to be linked by a bond, or a heterocyclic radical having 1, 2 or 3 rings containing 1, 2, 3 or 4 heteroatoms from the group consisting of O, N and S, or a combination thereof; the stated hydrocarbon, cycloalkyl, aromatic, araliphatic, and heteroaromatic radicals may be substituted by 1, 2, 3 or 4 substituents from the group consisting of OH, CN, F, Cl, Br, $NO_2$, $CF_3$, $C_1$-$C_6$-alkoxy, S-$C_1$-$C_6$-alkyl, $NHCONH_2$, NHC (NH) $NH_2$, NHCO-$C_1$-$C_6$-alkyl, $C_1$-$C_6$-alkyl, $CONR^5R^6$, $NR^5R^6$ and $SO_2$-$NR^5R^6$, $R^5$ and $R^6$ being alike or different and being hydrogen, phenyl or $C_1$-$C_6$- alkyl, with the proviso that there is at least one basic amino group in the stated hydrocarbon, cycloalkyl, aromatic, araliphatic or heteroaromatic radicals;

$R^{40}$ is hydrogen or $R^{30}$;

$G^+$ has the definition of $H^+$, alkali metal or substituted or unsubstituted ammonium ion.

2. The pigment preparation as claimed in claim 1, wherein

Q is a radical of C.I. Pigment Red 255 or of C.I. Pigment Red 264 or of C.I. Pigment Violet 19 or of Pigment Red 122;
$R^{30}$ is $C_2$-$C_4$-alkyl substituted by $NR^5R^6$, $R^5$ and $R^6$ being alike or different and being hydrogen or $C_1$-$C_4$- alkyl;
$R^{40}$ is hydrogen; and
$G^+$ is hydrogen, Li, Na, K or an ammonium ion.

3. The pigment preparation as claimed in claim 1 or 2, wherein the radical R2 is OH or O-$C_1$-$C_6$-alkyl.

4. The pigment preparation as claimed in claim 1 or 2, wherein the radical -CO-R2 is an amide group where R2 is $NH_2$,

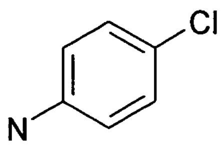
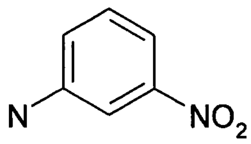
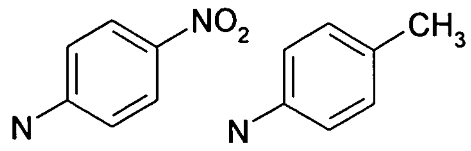
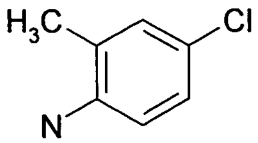
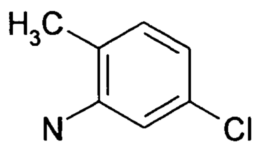
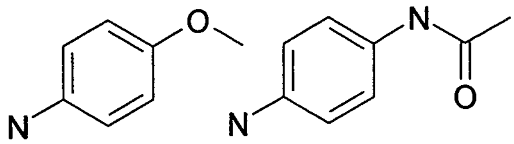
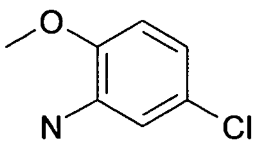
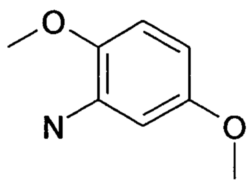
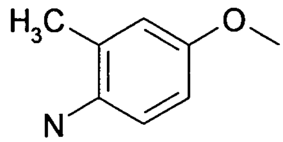
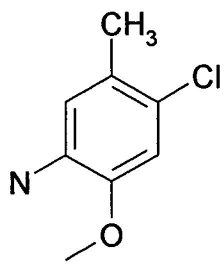
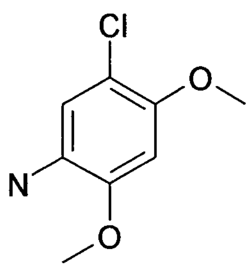
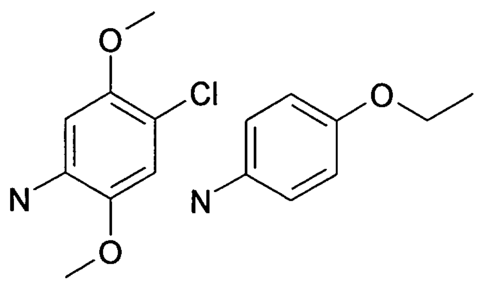
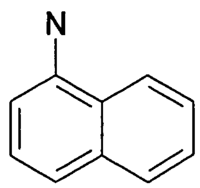
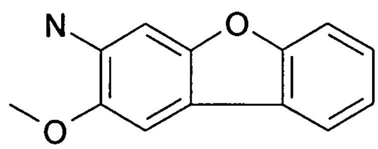
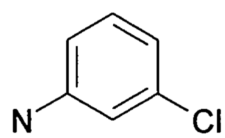

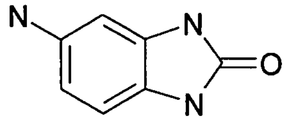

and in the above formulae the bond to the carbonyl group is via the free amino group N- of the aromatic ring.

**5.** The pigment preparation as claimed in one or more of claims 1 to 4, wherein the weight ratio of components b) and c) to one another is approximately 1:1.

**6.** A process for producing a pigment preparation as claimed in one or more of claims 1 to 5, which comprises admixing P.R. 254, during and/or after conversion to a fine state of subdivision, or during and/or after a finishing treatment, with the unlaked sulfo-containing monoazo dye and the pigment dispersant of the formula (5).

**7.** The use of a pigment preparation as claimed in one of more of claims 1 to 5 for pigmenting plastics, resins, coatings, especially metallic coatings, paints, electrophotographic toners and developers, electret materials, color filters, and also liquid inks, more particularly inkjet inks, and printing inks.

**8.** A color filter comprising a coloristically effective amount of a pigment preparation as claimed in one or more of claims 1 to 5.

## Revendications

**1.** Préparation pigmentaire, contenant

(a) du pigment C.I. Red 254 ayant une taille moyenne de particule $d_{50}$ d'au maximum 100 nm ;
(b) 0,1 à 30 % en poids, par rapport au poids du PR 254, d'un ou plusieurs dispersants choisis dans le groupe des colorants monoazoïques non laqués, contenant des groupes sulfo, de formule (I), (II), (III) ou (IV)

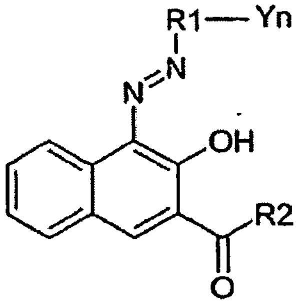
(I)

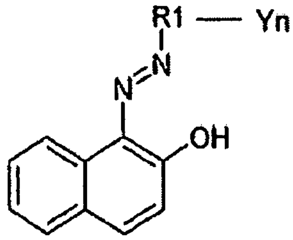
(II)

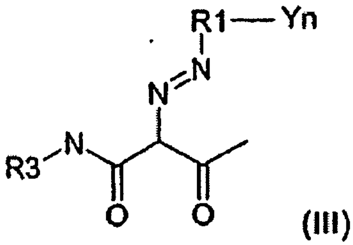
(III)

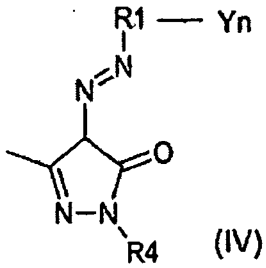
(IV)

Formules dans lesquelles

R1 représente un radical aromatique à 1, 2 ou 3 noyaux aromatiques, les noyaux pouvant être condensés ou être liés par une liaison, ou un radical hétérocyclique à 1, 2 ou 3 cycles, contenant 1, 2, 3 ou 4 hétéroatomes choisis dans le groupe constitué par O, N et S; ou une combinaison de ceux-ci ; lesdits radicaux aromatiques et hétéroaromatiques pouvant porter 1, 2, 3 ou 4 substituants choisis dans le groupe constitué par OH, CN, F, Cl, Br, $NO_2$, $CF_3$, alcoxy en $C_1$-$C_6$, S-alkyle($C_1$-$C_6$), $NHCONH_2$, $NHC(NH)NH_2$, NHCO-alkyle ($C_1$-$C_6$), alkyle en $C_1$-$C_6$, COOR5, CONR5R6, $SO_3R5$, $SO_2$-NR5R6 ou $COO^-E^+$, R5 et R6 étant identiques ou différents et représentant un atome d'hydrogène, un groupe phényle ou alkyle en $C_1$-$C_6$ et $E^+$ représentant un atome d'hydrogène, de lithium, sodium, potassium, rubidium, césium ou un ion ammonium non substitué ;
Y représente $SO_3^-E^+$ ou Z-$SO_3^-E^+$, Z représentant un groupe alkylène en $C_1$-$C_{10}$ ou phénylène ;
n représente le nombre 1, 2 ou 3 ;
R2 représente -$OR^8$ ou -$NHR^8$, $R^8$ représentant H, alkyle en $C_1$-$C_6$, benzyle, un radical aromatique à 1, 2 ou 3 noyaux aromatiques, les noyaux pouvant être condensés ou être liés par une liaison, ou un radical hétérocyclique à 1, 2 ou 3 cycles, contenant 1, 2, 3 ou 4 hétéroatomes choisis dans le groupe constitué par O, N et S ; ou une combinaison de ceux-ci ; lesdits radicaux aromatiques et hétéroaromatiques pouvant porter chacun 1, 2, 3 ou 4 substituants choisis dans le groupe constitué par OH, alcoxy en $C_1$-$C_6$, S-alkyle ($C_1$-$C_6$), halogène,, $NHCONH_2$, NHC (NH) $NH_2$, NHCO-alkyle ($C_1$-$C_6$), alkyle en $C_1$-$C_6$, nitro, COOR5, CONR5R6, $SO_3R5$, $SO_2$-NR5R6, $SO_3^-E^+$ ou $COO^-E^+$, R5 et R6 étant identiques ou différents et représentant un atome d'hydrogène, un groupe phényle ou alkyle en $C_1$-$C_6$ ;
R3 et R4 représentent chacun un radical aromatique à 1, 2 ou 3 noyaux aromatiques, les noyaux pouvant être condensés ou être liés par une liaison, ou un radical hétérocyclique à 1, 2 ou 3 cycles, contenant 1, 2, 3 ou 4 hétéroatomes choisis dans le groupe constitué par O, N et S ; ou une combinaison de ceux-ci ; lesdits radicaux aromatiques et hétéroaromatiques pouvant porter chacun 1, 2, 3 ou 4 substituants choisis dans le groupe constitué par OH, alcoxy en $C_1$-$C_6$, S-alkyle ($C_1$-$C_6$), halogène, $NHCONH_2$, $NHC(NH)NH_2$, NHCO-alkyle ($C_1$-$C_6$), alkyle en $C_1$-$C_6$, nitro, COOR5, CONR5R6, $SO_3R5$, $SO_2$-NR5R6, $SO_3^-E^+$ ou $COO^-E^+$, R5 et R6 étant identiques ou différents et représentant un atome d'hydrogène, un groupe phényle ou alkyle en $C_1$-$C_6$ ;

(c) 0,1 à 30 % en poids, par rapport au poids du PR 254, d'un dispersant pigmentaire basique de formule (5)

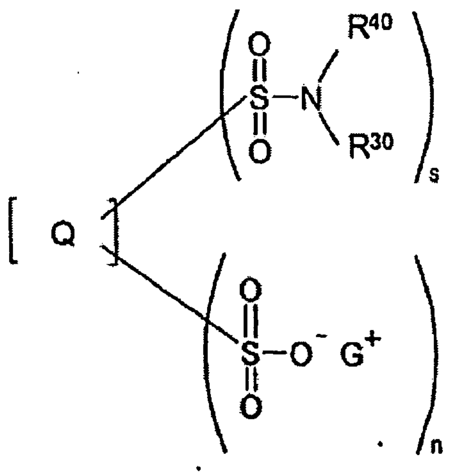

(5)

dans laquelle

Q représente un reste d'un pigment organique choisi dans le groupe des pigments périnone, quinacridone, quinacridonequinone, anthanthrone, indanthrone, dioxazine, dicétopyrrolopyrrole, indigo, thio-indigo, thiazine-indigo, iso- indoline, iso-indolinone, pyranthrone, isoviolanthrone, flavanthrone ou anthrapyrimidine ;
s représente un nombre valant de 1 à 5 ;
n représente un nombre valant de 0 à 4 ; la somme de s et n valant de 1 à 5, et s étant supérieur à n ;
$R^{30}$ représente un radical hydrocarboné aliphatique ramifié ou non ramifié, saturé ou insaturé, ayant de 1 à 20 atomes de carbone, ou un radical cycloalkyle en $C_5$-$C_7$, ou un radical araliphatique ou aromatique à 1, 2 ou 3 noyaux aromatiques, les noyaux pouvant être condensés ou liés par une liaison, ou un radical hétérocyclique à 1, 2 ou 3 cycles, contenant 1, 2, 3 ou 4 hétéroatomes choisis dans le groupe constitué par O, N et S, ou une combinaison de ceux-ci ; les radicaux hydrocarbonés, cycloalkyle, aromatiques,

araliphatiques et hétéroaromatiques nommés pouvant porter 1, 2, 3 ou 4 substituants choisis dans le groupe constitué par OH, CN, F, Cl, Br, $NO_2$, $CF_3$, alcoxy en $C_1$-$C_6$, S-alkyle ($C_1$-$C_6$), $NHCONH_2$, NHC (NH) $NH_2$, NHCO-alkyle ($C_1$-$C_6$), alkyle en $C_1$-$C_6$, $CONR^5R^6$, $NR^5R^6$, $SO_2$-$NR^5R^6$, $R^5$ et $R^6$ étant identiques ou différents et représentant un atome d'hydrogène, un groupe phényle ou alkyle en $C_1$-$C_6$, étant entendu qu'au moins un groupe amino basique est contenu dans les radicaux hydrocarbonés, cycloalkyle, aromatiques, araliphatiques ou hétéroaromatiques nommés ;
$R^{40}$ représente un atome d'hydrogène ou $R^{30}$;
$G^+$ représente $H^+$, un métal alcalin ou un ion ammonium substitué ou non substitué.

**2.** Préparation pigmentaire selon la revendication 1, **caractérisée en ce que**

Q représente un reste de pigment C.I. Red 255 ou de pigment C.I. Red 264 ou de pigment C.I. Violet 19 ou de pigment Red 122 ;
$R^{30}$ représente un groupe alkyle en $C_2$-$C_4$ qui est substitué par $NR^5R^6$, $R^5$ et $R^6$ étant identiques ou différents et représentant un atome d'hydrogène ou un groupe alkyle en $C_1$-$C_4$ ;
$R^{40}$ représente un atome d'hydrogène,
$G^+$ est un atome d'hydrogène, Li, Na, K ou un ion ammonium.

**3.** Préparation pigmentaire selon la revendication 1 ou 2, **caractérisée en ce que** le radical R2 représente OH ou un groupe O-alkyle($C_1$-$C_6$).

**4.** Préparation pigmentaire selon la revendication 1 ou 2, **caractérisée en ce que** le radical -CO-R2 représente un groupe amido où R2 est $NH_2$,

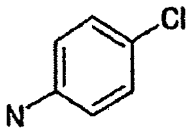 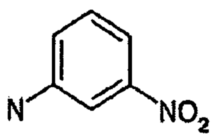 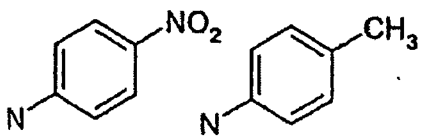

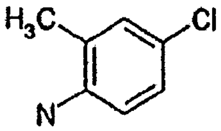 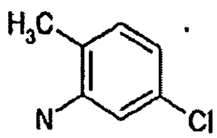 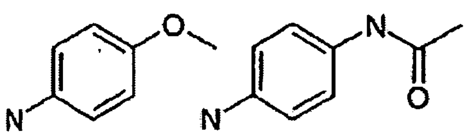

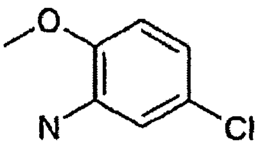 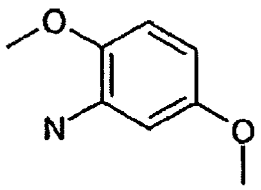 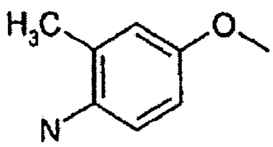

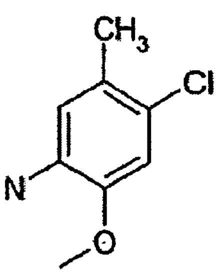 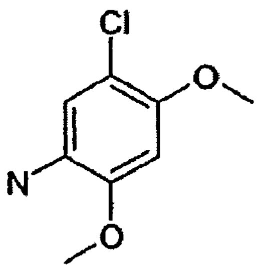 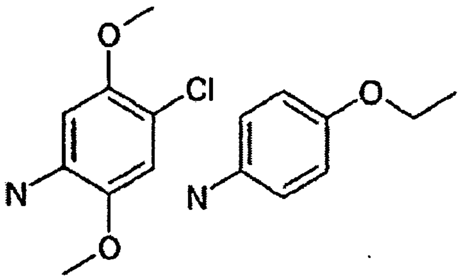

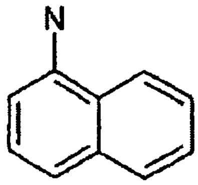
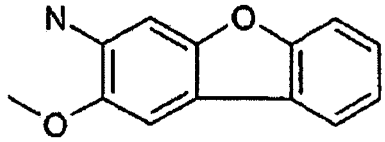
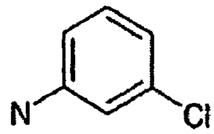

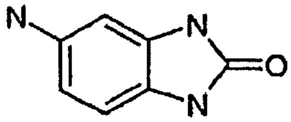

dans les formules précédentes la liaison au groupe carbonyle s'effectuant par le groupe amino N- libre du cycle aromatique.

5. Préparation pigmentaire selon une ou plusieurs des revendications 1 à 4, **caractérisée en ce que** le rapport pondéral des composants b) et c) entre eux est d'environ 1 : 1.

6. Procédé pour la préparation d'une préparation pigmentaire selon une ou plusieurs des revendications 1 à 5, **caractérisé en ce qu'**on mélange du P.R. 254, pendant et/ou après une fine division, ou pendant et/ou après un traitement de finition, avec le colorant monoazoïque non laqué, contenant des groupes sulfo, et le dispersant pigmentaire de formule (5).

7. Utilisation d'une préparation pigmentaire selon une ou plusieurs des revendications 1 à 5, pour la pigmentation de matières plastiques, de résines, de laques, en particulier de laques métallisées, de peintures, de toners et développeurs électrophotographiques, de matériaux électret, de filtres colorés ainsi que d'encres, en particulier d'encres pour impression par jet d'encre, d'encres d'imprimerie.

8. Filtre coloré, contenant une quantité, efficace pour la coloration, d'une préparation pigmentaire selon une ou plusieurs des revendications 1 à 5.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- JP 2005345884 A
- DE 10235573 A1
- EP 1884543 A1
- US 5869625 A
- JP 2001214107 A
- EP 1715007 A
- US 2006185558 A
- US 20080107977 A
- EP 1104789 A
- DE 3106906 A
- EP 3106906 A